(19) Europäisches Patentamt
European Patent Office
Office européen des brevets

(11) **EP 2 955 781 A1**

(12) **EUROPEAN PATENT APPLICATION**
published in accordance with Art. 153(4) EPC

(43) Date of publication:
**16.12.2015 Bulletin 2015/51**

(51) Int Cl.:
***H01M 14/00*** (2006.01)   ***H01L 31/04*** (2014.01)

(21) Application number: **13874844.7**

(86) International application number:
**PCT/JP2013/083823**

(22) Date of filing: **18.12.2013**

(87) International publication number:
**WO 2014/122859 (14.08.2014 Gazette 2014/33)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **06.02.2013   JP 2013021676**
**06.02.2013   JP 2013021674**
**30.03.2013   JP 2013075450**
**30.03.2013   JP 2013075453**

(71) Applicant: **Fujikura Ltd.**
**Tokyo 135-8512 (JP)**

(72) Inventors:
• **OKADA Kenichi**
**Sakura-shi**
**Chiba 285-8550 (JP)**

• **YAMAGUCHI Takeshi**
**Sakura-shi**
**Chiba 285-8550 (JP)**
• **TANABE Nobuo**
**Sakura-shi**
**Chiba 285-8550 (JP)**
• **TOPON Ong-on**
**Sakura-shi**
**Chiba 285-8550 (JP)**
• **USUI Hiroki**
**Sakura-shi**
**Chiba 285-8550 (JP)**
• **ENDO Katsuyoshi**
**Sakura-shi**
**Chiba 285-8550 (JP)**

(74) Representative: **Hoffmann Eitle**
**Patent- und Rechtsanwälte PartmbB**
**Arabellastraße 30**
**81925 München (DE)**

(54) **DYE-SENSITIZED SOLAR CELL ELEMENT**

(57) Provided is a dye-sensitized solar cell element including: at least one dye-sensitized solar cell; and a back sheet facing the at least one dye-sensitized solar cell, the at least one dye-sensitized solar cell including a conductive substrate, a current collector disposed on the conductive substrate, a counter substrate facing the conductive substrate, a power generation layer disposed on the conductive substrate or the counter substrate, an electrolyte disposed between the conductive substrate and the counter substrate, and an annular sealing portion enclosing the power generation layer and the electrolyte together with the conductive substrate and the counter substrate and joining the conductive substrate and the counter substrate, and the dye-sensitized solar cell element further including: an adhesive part adhering the back sheet and the conductive substrate in an annular region surrounding the at least one dye-sensitized solar cell, in which the current collector is provided only at an outer side of the sealing portion and only at the inner side of an outer peripheral surface of the adhesive part.

Fig.1

## Description

TECHNICAL FIELD

The present invention relates to a dye-sensitized solar cell element.

BACKGROUND ART

As photoelectric conversion elements, attention has been paid to dye-sensitized solar cell elements since high photoelectric conversion efficiency can be obtained at low cost. Thus, various developments have been implemented in relation to dye-sensitized solar cell elements.

As such a dye-sensitized solar cell element, for example, one described in Patent Document 1 described below is known. Patent Document 1 described below discloses a dye-sensitized solar cell including an upper electrode, a lower electrode, a power generation layer disposed on the upper electrode, an electrolyte disposed between the upper electrode and the lower electrode, and a sealing portion disposed on the circumference of the electrolyte and connecting the upper electrode and the lower electrode, in which the upper electrode has a transparent conductive film and a current collector formed on the transparent conductive film, and the current collector is provided to protrude from the inside of the sealing portion, that is the circumference of the power generation layer, to the outside of a cell boundary.

Further, as a dye-sensitized solar cell element, for example, one described in Patent Document 2 described below is also known. Patent Document 2 described below discloses a photoelectric conversion apparatus including: a dye-sensitized solar cell having a pair of electrodes, an electrolyte layer provided between the pair of electrodes, and a sealing material connecting the pair of electrodes at the circumference of the electrolyte layer; and a back sheet provided to be in close contact with one of the pair of electrodes and to be adhered to the sealing material. Here, the back sheet is configured such that a metal layer formed by aluminum is sandwiched by an adhesive layer formed by a hot-melt resin such as an ethylene-vinyl alcohol copolymer-based resin and a support film formed by polyethylene terephthalate.

CITATION LIST

PATENT DOCUMENT

Patent Document 1: JP 2006-244954 A
Patent Document 2: JP 2006-100069 A

SUMMARY OF THE INVENTION

PROBLEM TO BE SOLVED BY THE INVENTION

In the dye-sensitized solar cell described in the above Patent Document 1, a current collector is formed at the inside of the sealing portion that corresponds to the circumference of the power generation layer in order to effectively collect an electron generated in the power generation layer.

However, when the current collector is formed in the sealing portion, there is a concern that durability may be decreased. Accordingly, there is a room for improvement in terms of durability. On the other hand, when the width of the sealing portion is simply increased in order to improve the durability, the area of the power generation layer is decreased and thus conversion efficiency is decreased.

Further, regarding the photoelectric conversion apparatus described in the above Patent Document 2, there is a room for improvement in terms of durability. Furthermore, in the photoelectric conversion apparatus described in the above Patent Document 2, the backsheet is configured such that a metal layer formed by aluminum is sandwiched by an adhesive layer and a support film formed by polyethylene terephthalate and the back sheet is in close contact with one of the pair of electrodes. For this reason, in a case where the photoelectric conversion apparatus described in Patent Document 2 includes a plurality of dye-sensitized solar cells, the following problem arises. That is, normally, even if the back sheet is in contact with one of the pair of electrodes configuring the plurality of dye-sensitized solar cells, since the adhesive layer is interposed between the electrode and the metal layer of the back sheet, short circuit does not occur between the plurality of dye-sensitized solar cells. However, for example, when the photoelectric conversion apparatus is placed in high-temperature environment, the adhesive layer is melted so as to become thinner. As a result, it is considered that the metal layer of the back sheet is in contact with all of the electrodes of the plurality of dye-sensitized solar cells and thus short circuit occurs between the plurality of dye-sensitized solar cells.

The invention was made in consideration of the above-described circumstances, and a first object thereof is to provide a dye-sensitized solar cell element having excellent durability and conversion efficiency.

Further, a second object of the invention is to provide a dye-sensitized solar cell element having excellent durability and sufficiently capable of preventing occurrence of short circuit.

MEANS FOR SOLVING PROBLEM

The present inventors examined a factor causing the first object in the photoelectric conversion apparatus of Patent Document 1 described above. As a result, it was found that, in the dye-sensitized solar cell of Patent Document 1 described above, since the current collector is formed in a convex shape, the sealing portion is also formed along this convex shape and thus there is a concern that sealing performance may be decreased in the vicinity of the convex portion. Further, it was found that since the current collector is provided in the sealing portion, for example, even in the case of a small defect which has no influence on the sealing performance like a case where small cracks are generated in the sealing portion, the electrolyte and the current collector are in contact with each other and thus the current collector is corroded. Furthermore, it was found that, in the structure of the dye-sensitized solar cell of Patent Document 1 described above, when durability is intended to be improved while the current collector is provided in the sealing portion, the sealing width is increased by any means and thus the area of the power generation layer is decreased, and as a result, conversion efficiency is decreased. Accordingly, the present inventors conducted extensive studies and, as a result, they found that the first object can be solved by intentionally forming the current collector, which is typically provided in the vicinity of the power generation layer, only at the outer side of the sealing portion.

That is, the invention is a dye-sensitized solar cell element including: at least one dye-sensitized solar cell; and a back sheet facing the at least one dye-sensitized solar cell, the at least one dye-sensitized solar cell including a conductive substrate, a current collector disposed on the conductive substrate, a counter substrate facing the conductive substrate, a power generation layer disposed on the conductive substrate or the counter substrate, an electrolyte disposed between the conductive substrate and the counter substrate, and an annular sealing portion enclosing the power generation layer and the electrolyte together with the conductive substrate and the counter substrate and joining the conductive substrate and the counter substrate, and the dye-sensitized solar cell element further including: an adhesive part adhering the back sheet and the conductive substrate in an annular region surrounding the at least one dye-sensitized solar cell, in which the current collector is provided only at an outer side of the sealing portion and only at an inner side of an outer peripheral surface of the adhesive part.

According to this dye-sensitized solar cell element, the current collector is provided only at the outer side of the sealing portion and only at the inner side of the outer peripheral surface of the adhesive part adhering the back sheet and the conductive substrate. That is, since the current collector is not provided in the sealing portion, a decrease in the sealing performance of the sealing portion can be prevented. Further, since the current collector is not provided in the sealing portion, the corrosion of the current collector due to the electrolyte can also be prevented. Moreover, according to the dye-sensitized solar cell element, it is possible to sufficiently suppress the infiltration of moisture to the outer side of the sealing portion and the inner side of the outer peripheral surface of the adhesive part by the back sheet. It is also possible to sufficiently prevent the corrosion of the current collector due to moisture of ambient air, or the like. Therefore, the dye-sensitized solar cell element of the invention has excellent durability. Further, since the current collector is provided only at the outer side of the sealing portion, it is not necessary to increase the width of the sealing portion in order to improve durability. As a result, the area of the power generation layer can be increased and thus the conversion efficiency can be improved. Therefore, the dye-sensitized solar cell element of the invention can have excellent durability and conversion efficiency.

In the dye-sensitized solar cell element, it is preferable that the adhesive part be separated from the sealing portion.

In this case, a space is formed between the adhesive part and the sealing portion, and moisture penetrated from the outer side of the back sheet is retained in the space. That is, it is further sufficiently suppressed that moisture is immediately penetrated into the electrolyte. For this reason, it is possible to realize more excellent durability as compared with a case where the adhesive part and the sealing portion are not separated from each other.

It is preferable that the dye-sensitized solar cell element further include an external connecting portion for extracting current to the outside on the conductive substrate and only at an outer side of the adhesive part.

In this case, since the external connecting portion is provided only at the outer side of the adhesive part, it is possible to prevent the moisture or the like from passing through the inside of the external connecting portion and then being penetrated into the inner side of the adhesive part.

In the dye-sensitized solar cell element, it is preferable that the conductive substrate be configured by a first electrode having an insulating substrate, the counter substrate be configured by a second electrode, the back sheet have a metal layer, the annular region be positioned on the insulating substrate at the back sheet side, the adhesive part attach the back sheet and the annular region, the second electrode be disposed between the first electrode and the back sheet, and a distance between the first electrode and an interface between the back sheet and the adhesive part be larger than a distance between the first electrode and a surface of the second electrode at the back sheet side.

According to this dye-sensitized solar cell element, the adhesive part is separated from the sealing portion. For this reason, it is sufficiently suppressed that the adhesive part is contracted at low temperature so as to pull the sealing portion, and thus excessive stress is applied to the interface between the sealing portion and the first electrode or the second electrode. Moreover, it is also sufficiently suppressed that the adhesive part is expanded at high temperature so as to push the sealing portion, and thus excessive stress is applied to the interface between the sealing portion and the first electrode or the second electrode. That is, according to the dye-sensitized solar cell element of the invention, at either high temperature or low temperature, it is sufficiently suppressed that excessive stress is applied to the interface between the sealing portion and the first electrode or the second electrode. Therefore, according to the dye-sensitized solar cell element of the invention, excellent durability can be achieved. Further, in a case where the dye-sensitized solar cell element of the invention includes the plurality of dye-sensitized solar cell elements, the distance between the first electrode and the interface between the back sheet and the adhesive part is larger than the distance between the first electrode and the surface of the second electrode at the back sheet side. For this reason, the back sheet is less likely to be in contact with the second electrode, as compared with a case where the distance between the first electrode and the interface between the back sheet and the adhesive part is equal to or less than the distance between the first electrode and the surface of the second electrode at the back sheet side. Therefore, even when the dye-sensitized solar cell element is disposed in high temperature environment, it is sufficiently suppressed that the metal layer of the back sheet connects the second electrodes of the plurality of dye-sensitized solar cells. From these reasons, according to the dye-sensitized solar cell element of the invention, it is possible to sufficiently prevent occurrence of short circuit.

In the dye-sensitized solar cell element, it is preferable that the second electrode and the back sheet in the at least one dye-sensitized solar cell be connected to each other by an adhesive material.

In this case, since the second electrode and the back sheet are connected by an adhesive material, the approach of the back sheet to the second electrode is sufficiently suppressed by the adhesive material. Therefore, occurrence of short circuit can be more sufficiently prevented. Further, since the back sheet and the second electrode are connected by an adhesive material, when thermal expansion or thermal contraction occurs in a space formed by the back sheet, the dye-sensitized solar cell, and the adhesive part, the stress to be applied to the back sheet is applied not only to the interface between the back sheet and the adhesive part, but also to the interface between the back sheet and the adhesive material. That is, it is sufficiently suppressed that the stress is concentrated in the interface between the back sheet and the adhesive part. As a result, the stress to be applied to the interface between the back sheet and the adhesive part is sufficiently decreased and it is sufficiently suppressed that the back sheet is released from the adhesive part. Therefore, the dye-sensitized solar cell element of the invention can have more excellent durability.

In the dye-sensitized solar cell element, it is preferable that the at least one dye-sensitized solar cell further include a drying material provided between the second electrode and the back sheet.

In this case, since moisture, which has been penetrated into a space formed by the back sheet, the dye-sensitized solar cell, and the adhesive part, is absorbed by the drying material, the moisture which is penetrated into the electrolyte through the sealing portion can be sufficiently reduced. Therefore, the dye-sensitized solar cell element of the invention can have more excellent durability. Further, since the drying material is provided between the second electrode and the back sheet, incident light is also not blocked.

In the dye-sensitized solar cell element, it is preferable that the drying material and the second electrode be connected to each other by an adhesive material, and the drying material and the back sheet be connected to each other by an adhesive material.

In this case, as compared with a case where the drying material and the second electrode are connected to each other by the adhesive material, and the drying material and the back sheet are not connected to each other by the adhesive material, it is possible to more sufficiently suppress the positional deviation of the drying material with respect to each dye-sensitized solar cell and the release of the drying material from each dye-sensitized solar cell. For this reason, the effect of absorbing moisture which has been penetrated into a space formed by the back sheet, the dye-sensitized solar cell, and the adhesive part is less likely to vary. As a result, the dye-sensitized solar cell element of the invention can stably have more excellent durability.

In the dye-sensitized solar cell element, it is preferable that the second electrode be provided between the first electrode and the back sheet, the drying material be disposed between the second electrode and the back sheet to be in contact with the second electrode, and a first space be formed between the back sheet and an outer region of the second electrode at the interface between the drying material and the second electrode such that the first space is in contact with the outer region and the drying material.

According to this dye-sensitized solar cell element, the first space is formed between the back sheet and an outer region of the second electrode at the interface between the drying material and the second electrode such that the first space is in contact with the outer region. For this reason, moisture, which is penetrated from the outer side of the back sheet into the dye-sensitized solar cell side through the back sheet, is likely to collect in the first space. Here, since the first space is formed to be in contact with the drying material, the moisture collected in the first space is absorbed by the drying material. As a result, since the moisture concentration in the first space is low at all times, moisture is likely to collect in the first space. Further, the first space is formed to be in contact with the outer region of the second electrode, and normally, moisture is less likely to be permeated to the second electrode as compared with the sealing portion. For this reason, it is sufficiently suppressed that moisture is penetrated into the electrolyte of the dye-sensitized solar cell. As a result, the dye-sensitized solar cell element of the invention can have more excellent durability.

In the dye-sensitized solar cell element, it is>>>>> preferable that a second space be formed between the back sheet and the sealing portion and the second space be communicated with the first space.

In this case, moisture may be penetrated from the outer side of the back sheet into the second space through the back sheet in some cases. Since the second space is formed between the back sheet and the sealing portion, when moisture is penetrated into the second space, normally, the moisture is easily penetrated into the electrolyte through the sealing portion. In this regard, in the invention, the second space is communicated with the first space. Moreover, since the moisture collected in the first space is absorbed by the drying material, the moisture concentration in the first space is maintained in a low concentration state at all times. For this reason, the moisture collected in the second space is likely to be diffused to the first space. Therefore, it is more sufficiently suppressed that the moisture collected in the second space is penetrated into the electrolyte through the sealing portion.

In the dye-sensitized solar cell element, it is preferable that the drying material be fixed to the second electrode in the at least one dye-sensitized solar cell.

In this case, since the drying material is fixed to the second electrode, the positional deviation of the drying material with respect to the second electrode is less likely to occur. Therefore, excellent durability can be stably achieved.

It is preferable that the dye-sensitized solar cell element have a plurality of dye-sensitized solar cells, the second electrodes of the two adjacent dye-sensitized solar cells be separated from each other, and another drying material be further provided across the second electrodes of the two adjacent dye-sensitized solar cells.

When the second electrodes of the two adjacent dye-sensitized solar cells are separated from each other, the sealing portion of the two adjacent dye-sensitized solar cells is likely to be exposed to moisture. In this regard, in a case where the second electrodes of the two adjacent dye-sensitized solar cells are separated from each other, when another drying material is further provided across the second electrodes of the two adjacent dye-sensitized solar cells, moisture is sufficiently absorbed by the another drying material. For this reason, the sealing portion is less likely to be exposed to moisture. As a result, it is sufficiently suppressed that moisture is penetrated into the electrolyte through the sealing portion. Therefore, this dye-sensitized solar cell element can have more excellent durability.

Further, it is preferable that the dye-sensitized solar cell element be a dye-sensitized solar cell element for low illumination which is used in low illumination environment. In the case of use in the low illumination environment, since generated current is small, even when the current collector is present only at the outer side of the sealing portion, an increase in resistance can be sufficiently prevented and thus the dye-sensitized solar cell element can have more excellent conversion efficiency.

In the dye-sensitized solar cell element, it is preferable that the at least one dye-sensitized solar cell be configured by a plurality of dye-sensitized solar cells, the conductive substrate have a conductive film provided on the insulating substrate, the insulating substrate of the plurality of dye-sensitized solar cells be used as an insulating substrate that is common to the plurality of dye-sensitized solar cells, and each of the conductive film of the plurality of dye-sensitized solar cells be provided on the common transparent substrate.

Even in this dye-sensitized solar cell element, since the current collector is provided only at the outer side of the sealing portion, excellent durability and conversion efficiency can be achieved.

In the dye-sensitized solar cell element, it is preferable that the current collector be provided at the outer side of the sealing portion and only at a portion other than the portion between the two adjacent dye-sensitized solar cells.

In this case, since the current collector is also not provided between the two adjacent dye-sensitized solar cells, an area not contributing to power generation between the two adjacent dye-sensitized solar cells can be decreased and it is possible to increase the area of the power generation layer by the decrease in the area not contributing to power generation. Therefore, it is possible to further improve conversion efficiency.

Further, the present inventors examined a factor causing the second object in the photoelectric conversion apparatus of Patent Document 2 described above. As a result, they thought that, in the photoelectric conversion apparatus of Patent Document 2 described above, since a hot-melt resin having a large linear expansion coefficient is used as an adhesive layer included in the back sheet, the hot-melt resin is contracted at low temperature so as to pull the sealing material and thus excessive stress may be applied to an interface between the sealing material and the electrode. On the other hand, they thought that the hot-melt resin is expanded at high temperature so as to push the sealing material and thus excessive stress may be applied to the interface between the sealing material and the electrode. As a result, the present inventors thought that, since the adhesion force between the sealing material and the electrode becomes weak, moisture is easily penetrated and thus durability may easily be decreased. Further, the present inventors thought that, in a case where the photoelectric conversion apparatus of Patent Document 2 described above is configured to include at least one dye-sensitized solar cell, the contact of the back sheet with one of the pair of electrodes included in the dye-sensitized solar cell may lead to the occurrence of short circuit. Accordingly, the present inventors conducted extensive studies and, as a result, they found that the second object can be solved by the following invention.

That is, the invention is a dye-sensitized solar cell element including: at least one dye-sensitized solar cell; and a back sheet facing the at least one dye-sensitized solar cell, the dye-sensitized solar cell including a first electrode having an insulating substrate, a second electrode facing the first electrode, a power generation layer provided between the first electrode and the second electrode and on the first electrode or the second electrode, an annular sealing portion joining the first electrode and the second electrode, and an electrolyte disposed in a space formed by the first electrode, the second electrode, and the sealing portion, in which the insulating substrate is configured as an insulating substrate of the at least one dye-sensitized solar cell, the back sheet has a metal layer, an adhesive part adhering the back sheet and an annular region, which is positioned on the insulating substrate at the back sheet side and surrounds the at least one dye-sensitized solar cell, and separated from the sealing portion is provided, the second electrode is disposed between the first electrode and the back sheet, and a distance between the first electrode and an interface between the back sheet and the adhesive part is larger than a distance between the first electrode and a surface of the second electrode at the back sheet side.

According to this dye-sensitized solar cell element, the adhesive part is separated from the sealing portion. For this reason, it is sufficiently suppressed that the adhesive part is contracted at low temperature so as to pull the sealing portion, and thus excessive stress is applied to the interface between the sealing portion and the first electrode or the second electrode. Moreover, it is also sufficiently suppressed that the adhesive part is expanded at high temperature so as to push the sealing portion, and thus excessive stress is applied to the interface between the sealing portion and the first electrode or the second electrode. That is, according to the dye-sensitized solar cell element of the invention, at either high temperature or low temperature, it is sufficiently suppressed that excessive stress is applied to the interface between the sealing portion and the first electrode or the second electrode. Therefore, according to the dye-sensitized solar cell element of the invention, excellent durability can be achieved. Further, in the dye-sensitize solar cell element of the invention, the distance between the first electrode and the interface between the back sheet and the adhesive part is larger than the distance between the first electrode and the surface of the second electrode at the back sheet side. For this reason, the back sheet is less likely to be in contact with the second electrode, as compared with a case where the distance between the first electrode and the interface between the back sheet and the adhesive part is equal to or less than the distance between the first electrode and the surface of the second electrode at the back sheet side. Therefore, even when the dye-sensitized solar cell element is disposed in high temperature environment, it is sufficiently prevented that the metal layer of the back sheet connects the second electrodes of the plurality of dye-sensitized solar cells. From these reasons, according to the dye-sensitized solar cell element of the invention, it is possible to sufficiently prevent occurrence of short circuit.

In the dye-sensitized solar cell element, it is preferable that the second electrode and the back sheet in the at least one dye-sensitized solar cell of the plurality of dye-sensitized solar cells be connected to each other by an adhesive material.

In this case, since the second electrode and the back sheet are connected by an adhesive material, the approach of the back sheet to the second electrode is sufficiently suppressed by the adhesive material. Therefore, occurrence of short circuit can be more sufficiently prevented. Further, since the back sheet and the second electrode are connected by an adhesive material, when thermal expansion or thermal contraction occurs in a space formed by the back sheet, the dye-sensitized solar cell, and the adhesive part, the stress to be applied to the back sheet is applied not only to the interface between the back sheet and the adhesive part, but also to the interface between the back sheet and the adhesive material. That is, it is sufficiently suppressed that the stress is concentrated in the interface between the back sheet and the adhesive part. As a result, the stress to be applied to the interface between the back sheet and the adhesive part is sufficiently decreased and it is sufficiently suppressed that the back sheet is released from the adhesive part. Therefore, the dye-sensitized solar cell element of the invention can have more excellent durability.

In the dye-sensitized solar cell element, it is preferable that the at least one dye-sensitized solar cell of the plurality of dye-sensitized solar cells further include a drying material provided between the second electrode and the back sheet.

In this case, since moisture, which has been penetrated into a space formed by the back sheet, the dye-sensitized solar cell, and the adhesive part, is absorbed by the drying material, the moisture which is penetrated into the electrolyte through the sealing portion can be sufficiently reduced. Therefore, the dye-sensitized solar cell element of the invention can have more excellent durability. Further, since the drying material is provided between the second electrode and the back sheet, incident light is also not blocked.

In the dye-sensitized solar cell element, it is preferable that the drying material and the second electrode be connected to each other by an adhesive material, and the drying material and the back sheet be connected to each other by an adhesive material.

In this case, as compared with a case where the drying material and the second electrode are connected to each other by the adhesive material, and the drying material and the back sheet are not connected to each other by the adhesive material, it is possible to more sufficiently suppress the positional deviation of the drying material with respect to each dye-sensitized solar cell and the release of the drying material from each dye-sensitized solar cell. For this reason, the effect of absorbing moisture which has been penetrated into a space formed by the back sheet, the dye-sensitized solar cell, and the adhesive part is less likely to vary. As a result, the dye-sensitized solar cell element of the invention can stably have more excellent durability.

EFFECT OF THE INVENTION

According to the invention, a dye-sensitized solar cell element having excellent durability and conversion efficiency is provided.

Further, according to the invention, a dye-sensitized solar cell element having excellent durability and capable of sufficiently preventing occurrence of short circuit is provided.

BRIEF DESCRIPTION OF DRAWINGS

Fig. 1 is a cross-sectional view illustrating a first embodiment of a dye-sensitized solar cell element of the invention;
Fig. 2 is a plan view illustrating a part of the first embodiment of the dye-sensitized solar cell element of the invention;
Fig. 3 is a plan view illustrating a pattern of a transparent conductive film in the dye-sensitized solar cell element of Fig. 1;
Fig. 4 is a plan view illustrating a first integrated sealing portion of Fig. 1;
Fig. 5 is a plan view illustrating a second integrated sealing portion of Fig. 1;
Fig. 6 is a cross-sectional view taken along the VI-VI line of Fig. 2;
Fig. 7 is a plan view illustrating a working electrode to which a sealing portion and a connecting portion are stuck;
Fig. 8 is a plan view illustrating a first integrated sealing portion molded body used for forming the first integrated sealing portion of Fig. 4;
Fig. 9 is a cross-sectional view illustrating a second embodiment of a dye-sensitized solar cell element of the invention;
Fig. 10 is a plan view illustrating a part of the dye-sensitized solar cell element of Fig. 9;
Fig. 11 is a plan view illustrating a second integrated sealing portion of Fig. 9;
Fig. 12 is a cross-sectional view taken along the XII-XII line of Fig. 10;
Fig. 13 is a cross-sectional view illustrating a third embodiment of a dye-sensitized solar cell element of the invention;
Fig. 14 is a cross-sectional view illustrating a fourth embodiment of a dye-sensitized solar cell element of the invention;
Fig. 15 is a cross-sectional view illustrating a fifth embodiment of a dye-sensitized solar cell element of the invention;
Fig. 16 is a cross-sectional view illustrating a sixth embodiment of a dye-sensitized solar cell element of the invention;
Fig. 17 is a cross-sectional view illustrating a seventh embodiment of a dye-sensitized solar cell element of the invention;
Fig. 18 is a plan view illustrating a part of an eighth embodiment of a dye-sensitized solar cell element of the invention;
Fig. 19 is a plan view illustrating a part of a ninth embodiment of a dye-sensitized solar cell element of the invention;
Fig. 20 is a plan view illustrating a part of a tenth embodiment of a dye-sensitized solar cell element of the invention;
Fig. 21 is a cross-sectional view illustrating an eleventh embodiment of a dye-sensitized solar cell element of the invention;
Fig. 22 is a partial enlarged view illustrating a porous inorganic portion of Fig. 21; and
Fig. 23 is a plan view illustrating a part of a twelfth embodiment of a dye-sensitized solar cell element of the invention.

MODE(S) FOR CARRYING OUT THE INVENTION

Hereinafter, embodiments of the invention will be described in detail.

<First Embodiment>

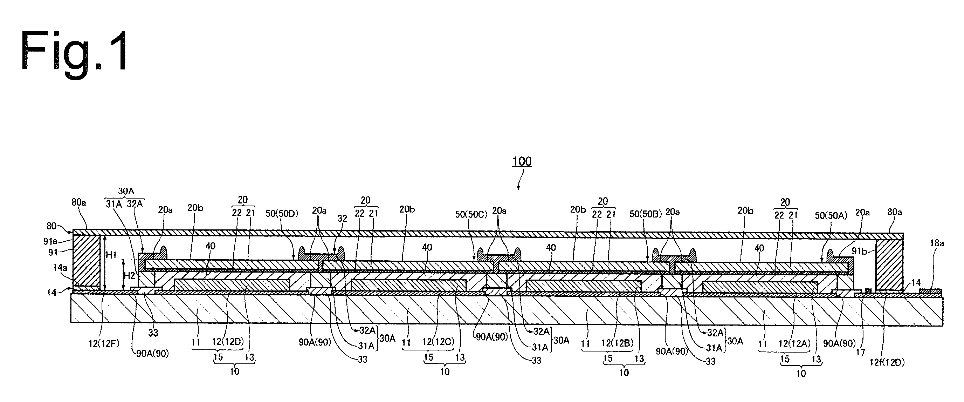

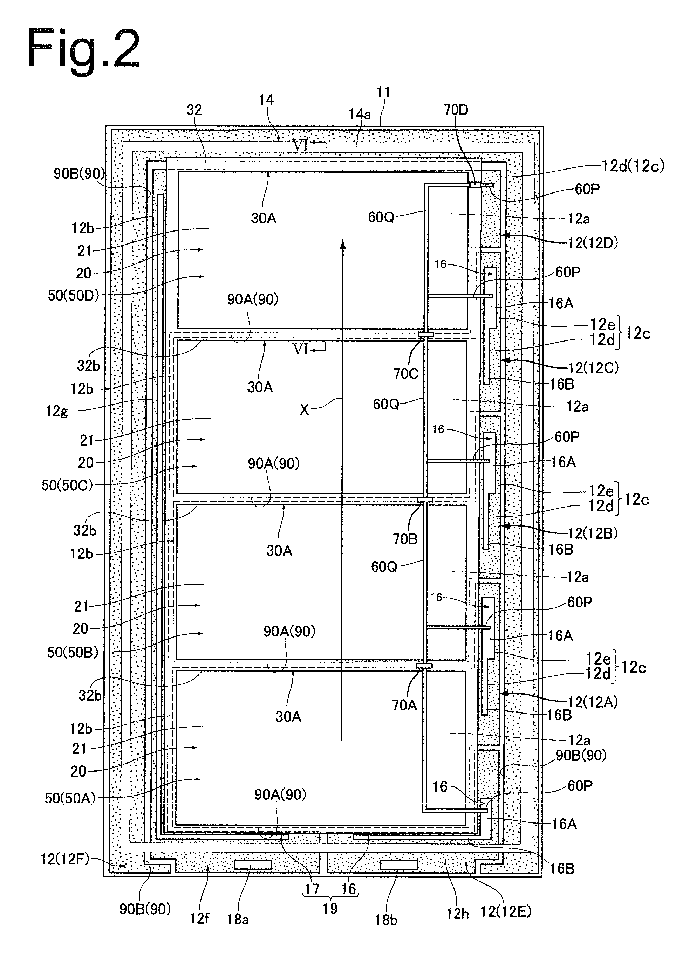

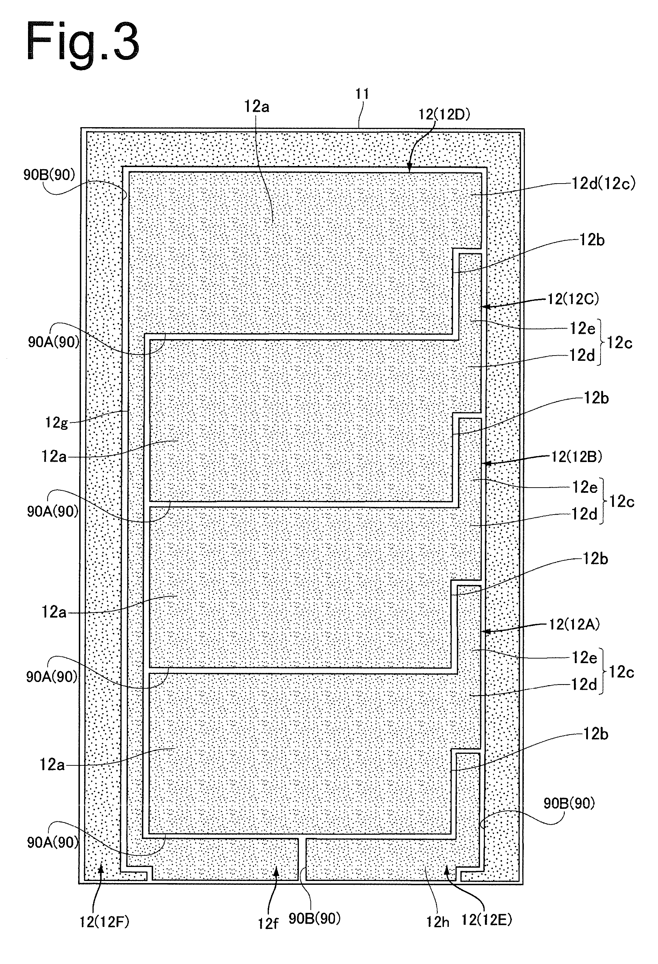

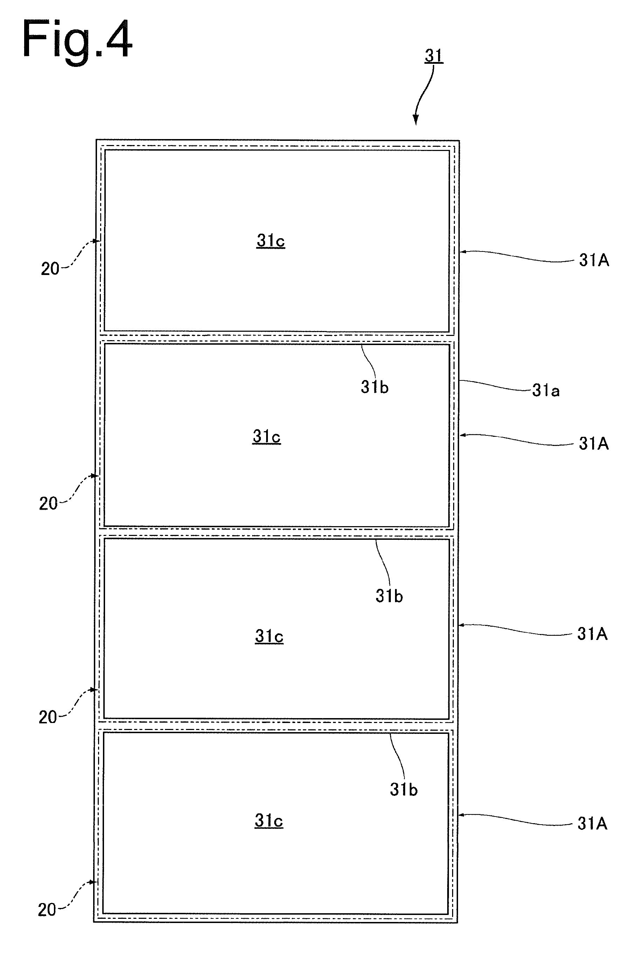

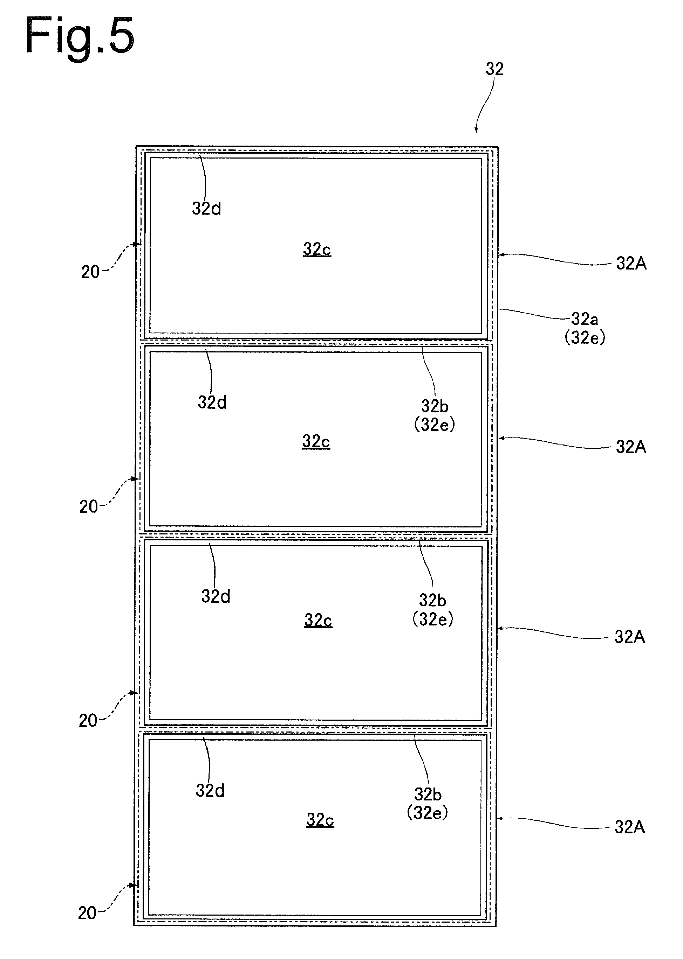

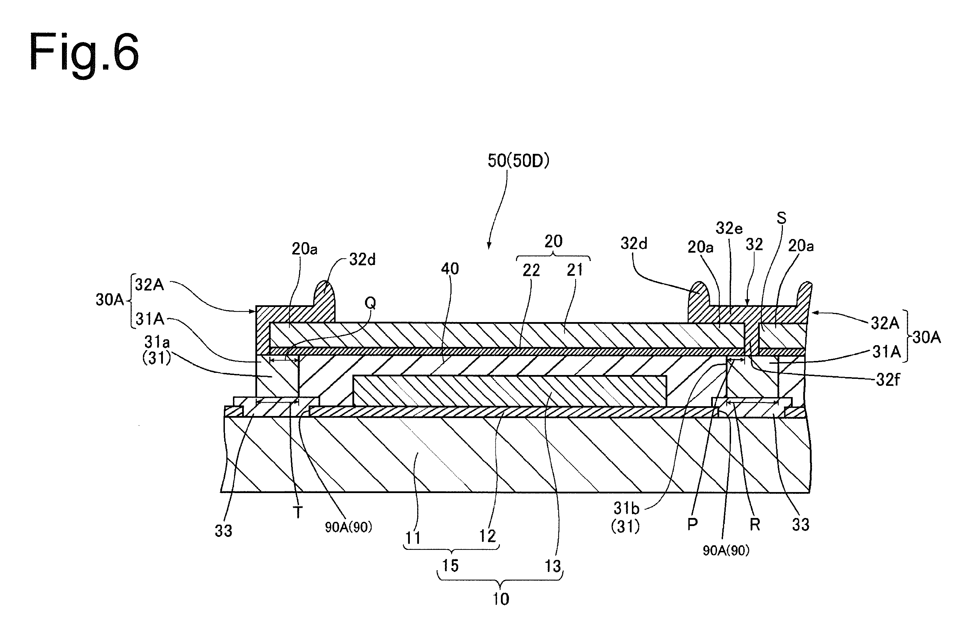

First, a first embodiment of a dye-sensitized solar cell element of the invention will be described in detail with reference to Fig. 1 to Fig. 7. Fig. 1 is a cross-sectional view illustrating the first embodiment of the dye-sensitized solar cell element of the invention, Fig. 2 is a plan view illustrating a part of the first embodiment of the dye-sensitized solar cell element of the invention, Fig. 3 is a plan view illustrating a pattern of a transparent conductive film in a dye-sensitized solar cell module of Fig. 1, Fig. 4 is a plan view illustrating a first integrated sealing portion of Fig. 1, Fig. 5 is a plan view illustrating a second integrated sealing portion of Fig. 1, Fig. 6 is a cross-sectional view taken along the VI-VI line of Fig.

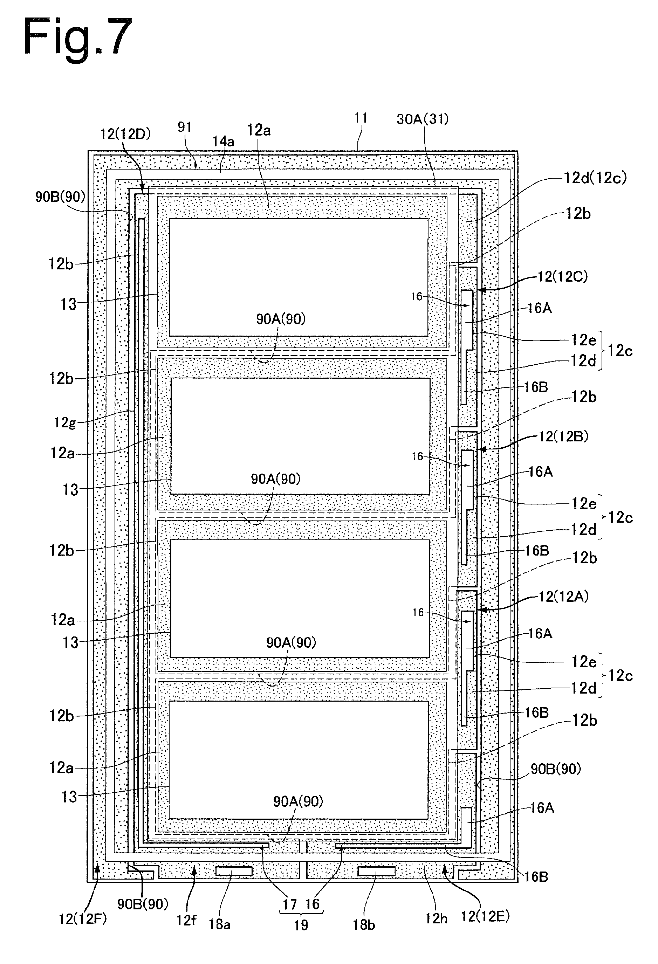

2, and Fig. 7 is a plan view illustrating a working electrode to which a sealing portion and a connecting portion are stuck.

As illustrated in Fig. 1, a dye-sensitized solar cell module (hereinafter, may be referred to as the "DSC module") 100 as a dye-sensitized solar cell element includes a plurality (four in Fig. 1) of dye-sensitized solar cells (hereinafter, may be referred to as the "DSC") 50, and a back sheet 80 disposed to face the DSCs 50. As illustrated in Fig. 2, the plurality of DSCs 50 are connected in series by conductive materials 60P. Hereinafter, for the convenience of explanation, four DSCs 50 in the DSC module 100 may be referred to as the DSC 50A to DSC 50D.

As illustrated in Fig. 1, each of the plurality of DSCs 50 is equipped with a working electrode 10, a counter electrode 20 facing the working electrode 10, and an annular sealing portion 30A bonding the working electrode 10 and the counter electrode 20. An electrolyte 40 is filled in the cell space formed by the working electrode 10, the counter electrode 20, and the annular sealing portion 30A.

The counter electrode 20 is equipped with a metal substrate 21 and a catalyst layer 22 which is provided to the working electrode 10 side of the metal substrate 21 and promotes the catalytic reaction. In addition, in two adjacent DSCs 50, the counter electrodes 20 are spaced apart from each other. In the present embodiment, a counter substrate and a second electrode is constituted by the counter electrode 20.

As illustrated in Fig. 1 and Fig. 2, the working electrode 10 has a transparent conductive substrate 15 having a transparent substrate 11 and a transparent conductive film 12 provided on the transparent substrate 11, a plurality of oxide semiconductor layers 13 provided on the transparent conductive film 12 of the transparent conductive substrate 15, and a current collector 19 provided on the transparent conductive film 12. The oxide semiconductor layer 13 is disposed at the inner side of the annular sealing portion 30A. The transparent substrate 11 is used as a transparent substrate that is common to DSC 50A to DSC 50D. Incidentally, in this embodiment, a conductive substrate and a first electrode are configured by the transparent conductive substrate 15, a power generation layer is configured by the oxide semiconductor layer 13, an insulating substrate is configured by the transparent substrate 11, and a conductive film is configured by the transparent conductive film 12.

As illustrated in Fig. 2 and Fig. 3, the transparent conductive film 12 is constituted by the transparent conductive films 12A to 12F provided in a state of being insulated from each other. In other words, the transparent conductive films 12A to 12F are disposed to interpose a groove 90 between one another. Here, the transparent conductive films 12A to 12D constitute the transparent conductive film 12 of the plurality of DSCs 50A to 50D, respectively. In addition, the transparent conductive film 12E is disposed so as to bend along the sealing portion 30A. The transparent conductive film 12F is the annular transparent electrode film 12 for fixing the peripheral portion 80a of the back sheet 80 (see Fig. 1).

As illustrated in Fig. 3, the transparent conductive films 12A to 12D all have a quadrangular-shaped main body portion 12a having a lateral edge 12b, and a extending portion 12c laterally protruding from the lateral edge 12b of the main body portion 12a.

As illustrated in Fig. 2, the extending portion 12c of the transparent conductive film 12C among the transparent conductive films 12A to 12D has a projecting portion 12d which laterally projects with respect to the arrangement direction X of the DSCs 50A to 50D and a facing portion 12e which extends from the projecting portion 12d and faces the main body portion 12a of the adjacent DSC 50D via the groove 90.

In the DSC 50B as well, the extending portion 12c of the transparent conductive film 12B has the projecting portion 12d and the facing portion 12e. In addition, in the DSC 50A as well, the extending portion 12c of the transparent conductive film 12A has the projecting portion 12d and the facing portion 12e.

Meanwhile, the DSC 50D is connected with the DSC 50C already and there is no other DSC 50 to be connected. For this reason, in the DSC 50D, the extending portion 12c of the transparent conductive film 12D does not have a facing portion 12e. In other words, the extending portion 12c of the transparent conductive film 12D is constituted by only the projecting portion 12d.

However, the transparent conductive film 12D further has a first current extracting portion 12f for extracting the current generated in the DSC module 100 to the outside and a connecting portion 12g which connects the first current extracting portion 12f and the main body portion 12a and extends along the side edge portion 12b of the transparent conductive films 12A to 12C. The first current extracting portion 12f is disposed in the vicinity of the DSC 50A and on the side opposite to the transparent conductive film 12B with respect to the transparent conductive film 12A.

Meanwhile, the transparent conductive film 12E also has a second current extracting portion 12h for extracting current generated in the DSC module 100 to the outside, and the second current extracting portion 12h is disposed on the circumference of the DSC 50A and at the side opposite to the transparent conductive film 12B with respect to the transparent conductive film 12A. Further, the first current extracting portion 12f and the second current extracting portion 12h are disposed on the circumference of the DSC 50A to be adjacent to each other with the groove 90 interposed therebetween. Here, the groove 90 is configured by a first groove 90A formed along the edge of the main body portion 12a of the transparent conductive film 12 and a second groove 90B formed along the edge of a portion of the transparent conductive film 12 excluding the main body portion 12a and intersecting with the peripheral edge 80a of the back sheet 80.

Further, the current collector 19 is provided on the transparent conductive film 12. The current collector 19 has a connection terminal 16 provided on each of the extending portions 12c of the transparent conductive films 12A to 12C and the transparent conductive film 12E and a current collecting wiring 17 provided on the transparent conductive film 12D.

In the present embodiment, in the transparent conductive films 12A to 12C, at least a conductive material connecting portion 16A of the connection terminal 16 is provided on the facing portion 12e of the extending portion 12c and faces the main body portion 12a of the adjacent DSC 50 to be connected. In the transparent conductive film 12E, the conductive material connecting portion 16A of the connection terminal 16 faces the main body portion 12a of the adjacent DSC 50A to be connected. Each connection terminal 16 has the conductive material connecting portion 16A which is connected with the conductive material 60P and extends along the sealing portion 30A on the outer side of the sealing portion 30A and a conductive material non-connecting portion 16B extending from the conductive material connecting portion 16A along the sealing portion 30A on the outer side of the sealing portion 30A. Moreover, the width of the conductive material non-connecting portion 16B is narrower than the width of the conductive material connecting portion 16A. Here, the width of the conductive material connecting portion 16A and the width of the conductive material non-connecting portion 16B are constant, respectively. Meanwhile, the width of the conductive material connecting portion 16A means the length in the direction orthogonal to the extending direction of the conductive material connecting portion 16A and the narrowest width of the width of the conductive material connecting portion 16A, and the width of the conductive material non-connecting portion 16B means the length in the direction orthogonal to the extending direction of the conductive material non-connecting portion 16B and the narrowest width of the width of the conductive material non-connecting portion 16B.

In addition, the conductive material connecting portion 16A of the connection terminal 16 provided on the extending portion 12c of the transparent conductive film 12C of the DSC 50C and the metal substrate 21 of the counter electrode 20 of the adjacent DSC 50D are connected via the conductive material 60P. The conductive material 60P is disposed so as to pass over the sealing portion 30A. In the same manner, the conductive material connecting portion 16A of the connection terminal 16 of the DSC 50B and the metal substrate 21 of the counter electrode 20 of the adjacent DSC 50C are connected via the conductive material 60P, and the conductive material connecting portion 16A of the connection terminal 16 of the DSC 50A and the metal substrate 21 of the counter electrode 20 of the adjacent DSC 50B are connected via the conductive material 60P. In addition, the conductive material connecting portion 16A of the connection terminal 16 on the transparent conductive film 12E and the metal substrate 21 of the counter electrode 20 of the adjacent DSC 50A are connected via the conductive material 60P.

In addition, in the transparent conductive film 12D, a current collecting wiring 17 having a lower resistance than the transparent conductive film 12D extends so as to pass through the main body portion 12a, the connecting portion 12g, and the current extracting portion 12f.

As illustrated in Fig. 7, the connection terminal 16 and the current collecting wire 17 serving as the current collector 19 are not provided at the inner side of the sealing portion 30A but provided only at the outer side of the sealing portion 30A. Further, the current collector 19 is not provided between two adjacent DSCs 50. Furthermore, the current collector 19 is formed in an adhesive resion surrounded by an outer peripheral surface 91a of an adhesive part 91 which will be described later. In other words, the current collector 19 is formed at the outer side in relation to the sealing portion 30A and only at the inner side in relation to the outer peripheral surface 91a of the adhesive part 91. Specifically, the current collector 19 is formed at the outer side in relation to the sealing portion 30A and only at the inner side in relation to an inner peripheral surface 91b of the adhesive part 91.

Further, each of external connecting portions 18a and 18b for extracting current to the outside is provided on the first current extracting portion 12f and the second current extracting portion 12h, respectively. As illustrated in Fig. 1 and Fig. 7, the external connecting portions 18a and 18b are formed at the outer side in relation to the adhesive part 91.

As illustrated in Fig. 1, the sealing portion 30A has an annular first sealing portion 31A provided between the transparent conductive substrate 15 and the counter electrode 20 and a second sealing portion 32A connected to the first sealing portion 31A and covering the lateral face of the counter electrode 20 and a part of a surface 20b of the counter electrode 20 at back sheet 80 side, which is a surface opposite to the electrolyte side. The second sealing portion 32A sandwiches an edge 20a of the counter electrode 20 together with the first sealing portion 31A. Further, as illustrated in Fig. 4, adjacent first sealing portions 31A are integrated to form a first integrated sealing portion 31. In other words, the first integrated sealing portion 31 is configured by an annular section (hereinafter, referred to as the "annular portion") 31a that is not provided between two adjacent counter electrodes 20 and a section (hereinafter, referred to as the "partitioning portion") 31b that is provided between two adjacent counter electrodes 20 and partitions an inner opening 31c of the annular portion 31a. Furthermore, as illustrated in Fig. 5, the second sealing portions 32A are integrated between the adjacent counter electrodes 20 to form a second integrated sealing portion 32. The second integrated sealing portion 32 is configured by an annular section (hereinafter, referred to as the "annular portion") 32a that is not provided between two adjacent counter electrodes 20, a section (hereinafter, referred to as the "partitioning portion") 32b that is provided between two adjacent counter electrodes 20 and partitions an inner opening 32c of the annular portion 32a, and a protruding portion 32d that is provided continuously to the inner opening 32c side of the annular portion 32a and the partitioning portion 32b.

Further, as illustrated in Fig. 1, an inorganic insulating material 33 is provided between the first sealing portion 31A and the groove 90 of the transparent conductive substrate 15 such that the inorganic insulating material 33 enters into the groove 90 between the adjacent transparent conductive films 12A to 12F and is provided across the adjacent transparent conductive films 12. Specifically, the inorganic insulating material 33 enters into the first groove 90A, which is formed along the edge of the main body portion 12a of the transparent conductive film 12, of the groove 90 and also covers the edge of the main body portion 12a forming the first groove 90A.

As illustrated in Fig. 6, the width P of the adhesive portion of the surface on the transparent conductive substrate 15 side of the counter electrode 20 and the partitioning portion 31b of the first integrated sealing portion 31 is narrower than the width Q of the adhesive portion of the surface on the transparent conductive substrate 15 side of the counter electrode 20 and the annular portion 31a of the first integrated sealing portion 31. Furthermore, the width R of the partitioning portion 31b of the first integrated sealing portion 31 is 100% or more and less than 200% of the width T of the annular portion 31a of the first integrated sealing portion 31.

Further, the second sealing portion 32A has a main body portion 32e provided at the side, which is opposite to the working electrode 10, of the counter electrode 20 and the above-described protruding portion 32d provided at the inner side in relation to the main body portion 32e and more protruding than the main body portion 32e toward the side opposite to the electrolyte 40. Further, the second sealing portions 32A form the second integrated sealing portion 32 by further including an adhesive part 32f provided between the adjacent counter electrodes 20. The second integrated sealing portion 32 is adhered to the first integrated sealing portion 31 by the adhesive part 32f. Furthermore, the main body portion 32e of the second sealing portion 32A is provided to extend beyond the upper region of the first sealing portion 31A up to the upper region of electrolyte 40, and the protruding portion 32d is provided in the upper region of electrolyte 40.

As illustrated in Fig. 1, the back sheet 80 is provided on the transparent conductive substrate 15. The back sheet 80 includes a main body portion configured by a laminate including a weather resistant layer and a metal layer, and an adhesive layer provided at the common transparent substrate 11 side of the main body portion and adhered to the transparent conductive substrate 15. The back sheet 80 has the counter electrode 20 between the back sheet 80 and the transparent conductive substrate 15 and is provided to be separated from the counter electrode 20. Further, the adhesive layer is adhered to the surface of the main body portion at the common transparent substrate 11 side, may be formed at the peripheral edge of the main body portion, or may be provided at the entire surface of the main body portion at the DSC 50 side. The peripheral edge 80a of the back sheet 80 is connected to the transparent conductive films 12D, 12E, and 12F of the transparent conductive film 12 through the connecting portion 14 by the adhesive part 91. Here, the adhesive part 91 is separated from the sealing portion 30A of the DSC 50. Further, the connecting portion 14 is also separated from the sealing portion 30A. Incidentally, a space at the inner side in relation to the back sheet 80 and at the outer side of the sealing portion 30A, that is, a space formed by the back sheet 80, the transparent substrate 11, and the adhesive part 91 is not filled with the electrolyte 40.

Further, in the DSC module 100, a distance (hereinafter, referred to as a "first distance") H1 between the transparent conductive substrate 15 and the interface between the adhesive part 91 and the back sheet 80 is larger than a distance (hereinafter, referred to as a "second distance") H2 between the transparent conductive substrate 15 and the surface of the counter electrode 20 at the back sheet 80 side.

Meanwhile, as illustrated in Fig. 2, bypass diodes 70A to 70D are connected in parallel with the DSCs 50A to 50D, respectively. Specifically, the bypass diode 70A is fixed on the partitioning portion 32b of the second integrated sealing portion 32 between the DSC 50A and the DSC 50B, the bypass diode 70B is fixed on the partitioning portion 32b of the second integrated sealing portion 32 between the DSC 50B and the DSC 50C, and the bypass diode 70C is fixed on the partitioning portion 32b of the second integrated sealing portion 32 between the DSC 50C and the DSC 50D. The bypass diode 70D is fixed on the sealing portion 30A of the DSC 50D. In addition, the conductive material 60Q is fixed to the metal substrate 21 of the counter electrode 20 so as to pass through the bypass diodes 70A to 70D. Moreover, the conductive material 60P branches out from the conductive materials 60Q between the bypass diodes 70A and 70B, between the bypass diodes 70B and 70C, and between the bypass diodes 70C and 70D, respectively, and is connected with the conductive material connecting portion 16A on the transparent conductive film 12A, the conductive material connecting portion 16A on the transparent conductive film 12B, and the conductive material connecting portion 16A on the transparent conductive film 12C, respectively. In addition, the conductive material 60P is also fixed to the metal substrate 21 of the counter electrode 20 of the DSC 50A, and this conductive material 60P connects the bypass diode 70A and the conductive material connecting portion 16A of the connection terminal 16 on the transparent conductive film 12E. Moreover, the bypass diode 70D is connected with the transparent conductive film 12D via the conductive material 60P.

According to the DSC module 100, the current collector 19 is provided only at the outer side of the sealing portion 30A and only at the inner side of the outer peripheral surface 91a of the adhesive part 91 adhering the back sheet 80 and the conductive substrate 15. That is, since the current collector 19 is not provided in the sealing portion 30A, it is possible to prevent sealing performance of the sealing portion 30A from being decreased. Further, since the current collector 19 is not provided in the sealing portion 30A, it is also possible to prevent corrosion of the current collector 19 due to the electrolyte 40. Moreover, according to the DSC module 100, it is possible to sufficiently suppress the infiltration of moisture to the outer side of the sealing portion 30A and the inner side of the outer peripheral surface 91a of the adhesive part 91 by the back sheet 80. It is also possible to sufficiently prevent the corrosion of the current collector 19 due to moisture of ambient air, or the like. Therefore, the DSC module 100 has excellent durability. Further, since the current collector 19 is provided only at the outer side of the sealing portion 30A, it is not necessary to increase the width of the sealing portion 30A in order to improve durability. As a result, the area of the oxide semiconductor layer 13 is increased and thus the conversion efficiency can be improved. Therefore, the DSC module 100 can have excellent durability and conversion efficiency.

Further, in the DSC module 100, since the transparent substrate 11 is used as the transparent substrate 11 that is common to a plurality of DSCs 50, each of the transparent conductive film 12 is provided on the common transparent substrate 11, and the current collector 19 is provided only at the outer side of the sealing portion 30A, the DSC module 100 can have excellent durability and conversion efficiency.

Further, in the DSC module 100, since the current collector 19 is provided at the outer side of the sealing portion 30A and only at a portion other than the portion between the two adjacent DSCs 50, and the current collector 19 is also not provided between the two adjacent DSCs 50, an area not contributing to electric generation between the two adjacent DSCs 50 can be decreased. As a result, it is possible to increase the area of the oxide semiconductor layer 13 and thus conversion efficiency can be further improved.

Further, in the DSC module 100, since the current collector 19 is provided at the outer side of the sealing portion 30A and only at the inner side of the adhesive part 91, the current collector 19 can be sufficiently prevented from being corroded due to moisture of ambient air, or the like while the corrosion of the current collector 19 due to the electrolyte 40 is prevented.

Further, in the DSC module 100, since the external connecting portion 18 is provided only at the outer side of the adhesive part 91, it is possible to prevent the moisture or the like from passing through the inside of the external connecting portion 18 and then being penetrated into the inner side of the adhesive part 91.

Further, in the DSC module 100, the second sealing portion 32A has the protruding portion 32d, which protrudes toward the side opposite to the electrolyte 40, at a part of the portion that covers the surface 20b, which is opposite to the electrolyte 40 side, of the counter electrode 20. For this reason, change in internal pressure, or stress to be applied to the sealing portion 30A due to the external force can be suppressed by the protruding portion 32d. Specifically, change in internal pressure, or stress generated by the external force is most applied to the sealing portion 30A that is a portion at which the transparent conductive substrate 15 and the counter electrode 20 are joined. However, the portion that covers the surface 20b, which is opposite to the electrolyte 40 side, of the counter electrode 20 of the second sealing portion 32A has the protruding portion 32d, and the protruding portion 32d becomes a singular point in the sealing portion 30A. Thus, the stress to be applied to the sealing portion 30A can be sufficiently absorbed by the protruding portion 32d. As a result, as compared with a case where the thickness of the portion that covers the surface 20b, which is opposite to the electrolyte 40 side, of the counter electrode 20 of the second sealing portion 32A is set to be constant and the area is increased, the breakage of the sealing portion 30A or the release between the first sealing portion 31A and the counter electrode 20 which is caused due to the stress can be suppressed. Therefore, the DSC module 100 can have excellent durability.

Further, in the DSC module 100, since the protruding portion 32d is provided in the region above the electrolyte 40, the stress, which is generated from the inside direction of the sealing portion 30A toward the sealing portion 30A, can be absorbed by the protruding portion 32d before the stress is applied to the interface between the counter electrode 20 and the first sealing portion 31A or the surface of the first sealing portion 31A at the electrolyte 40 side. According to this, the stress is less likely to be applied to the first sealing portion 31A. Therefore, the breakage of the sealing portion 30A or the release between the first sealing portion 31A and the counter electrode 20 can be further suppressed. Accordingly, the DSC module 100 can have more excellent durability.

Further, in the DSC module 100, since the inorganic insulating material 33 is provided between the first sealing portion 31A and the transparent conductive substrate 15 and the inorganic insulating material 33 has higher sealing performance than a resin, penetration of moisture from the outer side of the sealing portion 30A or leakage of the electrolyte 40 can be effectively suppressed as compared with a case where the inorganic insulating material 33 is not provided between the first sealing portion 31A and the transparent conductive substrate 15.

Further, according to the DSC module 100, the adhesive part 91 is separated from the sealing portion 30A of the DSC 50. For this reason, it is sufficiently suppressed that the adhesive part 91 is contracted at low temperature so as to pull the sealing portion 30A, and thus excessive stress is applied to the interface between the sealing portion 30A and the transparent conductive substrate 15 or the counter electrode 20. Moreover, it is also sufficiently suppressed that the adhesive part 91 is expanded at high temperature so as to push the sealing portion 30A, and thus excessive stress is applied to the interface between the sealing portion 30A and the transparent conductive substrate 15 or the counter electrode 20. That is, at either high temperature or low temperature, it is sufficiently suppressed that excessive stress is applied to the interface between the sealing portion 30A and the transparent conductive substrate 15 or the counter electrode 20. Therefore, the DSC module 100 can have excellent durability.

Further, in the DSC module 100, the first distance H1 is larger than the second distance H2. For this reason, the back sheet 80 is less likely to be in contact with the counter electrode 20 as compared with a case where the first distance H1 is equal to or less than the second distance H2. Therefore, even when the DSC module 100 is disposed in high temperature environment, it is sufficiently suppressed that the metal layer of the back sheet 80 connects the counter electrodes 20 of the plurality of DSCs 50. From these reasons, according to the DSC module 100, it is possible to sufficiently prevent occurrence of short circuit.

Further, in the DSC module 100, the groove 90 is formed along the edge of the transparent conductive film 12, and this groove 90 has the first groove 90A which is formed along the edge of the main body portion 12a of the transparent conductive film 12 disposed at the inner side of the annular sealing portion 30A. Then, the inorganic insulating material 33 enters into this first groove 90A, and this inorganic insulating material 33 also covers the edge of the main body portion 12a forming the first groove 90A. For this reason, even when cracks are formed, along the groove 90, at a position that is the inside of the transparent substrate 11 and is the lower portion of the groove 90 and these cracks are continued to the edge of the main body portion 12a, the penetration of moisture from the outside of the sealing portion 30A through these cracks is sufficiently suppressed by the inorganic insulating material 33. In particular, in the DSC module 100, since the inorganic insulating material 33, which covers the edge of the main body portion 12a forming the first groove 90A and enters into the first groove 90A, is formed by an inorganic material, the inorganic insulating material 33 has higher sealing performance as compared with a case where the inorganic insulating material 33 is formed by a resin. For this reason, according to the DSC module 100, it is possible to have excellent durability.

Further, in the DSC module 100, the sealing portion 30A and the inorganic insulating material 33 are disposed to overlap with each other. Therefore, as compared with a case where the inorganic insulating material 33 is disposed not to overlap with the sealing portion 30A, the area of a portion contributing to electric generation, when viewed from the light receiving surface side of the DSC module 100, can be further increased. Accordingly, the aperture ratio can be further improved.

In addition, in the DSC module 100, the first current extracting portion 12f and the second current extracting portion 12h are disposed in the vicinity of the DSC 50A and on the side opposite to the transparent conductive film 12B with respect to the transparent conductive film 12A, and the first current extracting portion 12f of the transparent conductive film 12A and the second current extracting portion 12h of the transparent conductive film 12F are disposed so as to be adjacent to each other via the groove 90. For this reason, in the DSC module 100, it is possible to dispose the external connection terminals 18a and 18b to the first current extracting portion 12f and second current extracting portion 12h, respectively, so as to be adjacent to each other. Hence, it is possible to set the number of connectors for extracting the current from the external connection terminals 18a and 18b to the outside to one. In other words, the first current extracting portion 12f and the second current extracting portion 12h are disposed to be greatly spaced apart from each other, for example, in a case in which the first current extracting portion 12f is disposed on the side opposite to the transparent conductive film 12C with respect to the transparent conductive film 12D. For this reason, the external connection terminals 18a and 18b are disposed to be greatly spaced apart from each other as well. In this case, two connectors of a connector to be connected with the external connection terminal 18a and a connector to be connected with the external connection terminal 18b are required in order to extract the current from the DSC module 100. However, according to the DSC module 100, only one connector is required since it is possible to dispose the external connection terminals 18a and 18b so as to be adjacent to each other. For this reason, according to the DSC module 100, it is possible to achieve space saving. In addition, the generated current is low when the DSC module 100 is used under a low illuminance. Specifically, the generated current is 2 mA or lower. For this reason, it is possible to sufficiently suppress the deterioration of the photoelectric conversion performance of the DSC module 100 even if a part of the transparent conductive film 12D of the DSC 50D on one end side of the DSC 50A and DSC 50D at both ends of the DSCs 50A to 50D is disposed next to the second current extracting portion 12h which is electrically connected with the metal substrate 21 of the counter electrode 20 of the DSC 50A on the other end side via the groove 90 as the first current extracting portion 12f.

In addition, in the DSC module 100, the DSCs 50A to 50D are arranged in a line along the X direction, the transparent conductive film 12D of the DSC 50D on one end side of the DSC 50A and DSC 50D at both ends of the DSCs 50A to 50D has the main body portion 12a provided on the inner side of the sealing portion 30A, the first current extracting portion 12f, and the connecting portion 12g which connects the main body portion 12a and the first current extracting portion 12f. For this reason, it is possible to more shorten the installation region of the connection terminal 16 provided along the arrangement direction (X direction in Fig. 2) of the DSCs 50A to 50D in order to connect two adjacent DSCs 50 compared to a case in which the DSCs 50C and 50D of a part of the DSCs 50A to 50D are folded back in the middle and the DSC 50A and the DSC 50D are disposed so as to be adjacent to each other, and thus it is possible to achieve space saving to a greater extent. Furthermore, according to the DSC module 100, the generated current is usually low in a case in which the DSC module 100 is used in a low illuminance environment. For this reason, it is possible to sufficiently suppress the deterioration of the photoelectric conversion characteristics although the DSC module 100 further has the first connecting portion 12g which connects the main body portion 12a and the first current extracting portion 12f.

Moreover, in the DSC module 100, the current collecting wiring 17 is disposed so as not to intersect with the coupling portion 14 of the adhesive portion 91 and the transparent conductive substrate 15 . It is possible to prevent the water vapor or the like from penetrating from the outside into the space formed by the back sheet 80, the transparent conductive substrate 15 and the adhesive portion 91 through the current collecting wiring 17 when the current collecting wiring 17 is disposed so as not to intersect with the coupling portion 14 of the transparent conductive substrate 15 and adhesive portion 91 although the current collecting wiring generally exhibits air permeability since it is porous and thus gas such as water vapor is permeable through it. As a result, it is possible for the DSC module 100 to exhibit excellent durability. Furthermore, it is possible to sufficiently suppress the deterioration of the photoelectric conversion characteristics even if the generated current increases since the current collecting wiring 17 has a lower resistance than the transparent conductive film 12D.

Furthermore, the connection terminal 16 is less likely to peel off from the extending portion 12c of the transparent conductive film 12 as the width of the connection terminal 16 is narrower in a case in which the DSC module 100 is placed in an environment in which the temperature change is great. With regard to that point, in the DSC module 100, the conductive material non-connecting portion 16B of the connection terminal 16 has a narrower width than the conductive material connecting portion 16A connected with the conductive material 60P. For this reason, the conductive material non-connecting portion 16B of the connection terminals 16 is less likely to peel off from the extending portion 12c of the transparent conductive film 12. Hence, the conductive material non-connecting portion 16B does not peel off from the transparent conductive film 12 and thus it is possible to maintain the connection with the transparent conductive film 12 even if the conductive material connecting portion 16A peels off from the extending portion 12c of the transparent conductive film 12. Furthermore, it is possible to normally operate the DSC module 100 even if the conductive material connecting portion 16A peels off from the extending portion 12c of the transparent conductive film 12. Consequently, according to the DSC module 100, it is possible to improve the connection reliability. In addition, the conductive material 60P connected with the metal substrate 21 of the counter electrode 20 of one DSC 50 of two adjacent DSCs 50 is connected with the conductive material connecting portion 16A on the extending portion 12c of the other DSC 50, and the conductive material connecting portion 16A is provided on the extending portion 12c and the outer side of the sealing portion 30A. In other words, the connection of two adjacent DSCs 50 is performed on the outer side of the sealing portion 30A. For this reason, according to the DSC module 100, it is possible to improve the aperture ratio.

In addition, in the DSC module 100, in the DSC 50 that is connected with the adjacent DSC 50 among the DSCs 50A to 50D, the extending portion 12c has the projecting portion 12d which laterally projects from the main body portion 12a and the facing portion 12e which extends from the projecting portion 12d and faces the main body portion 12a of the adjacent DSC 50, and at least the conductive material connecting portion 16A of the connection terminal 16 is provided on the facing portion 12e.

In this case, at least the conductive material connecting portion 16A of the connection terminal 16 is provided on the facing portion 12e facing the main body portion 12a of the adjacent DSC 50. For this reason, it is possible to sufficiently prevent the conductive material 60P connected with the conductive material connecting portion 16A from passing over the metal substrate 21 of the counter electrode 20 of the adjacent DSC 50 unlike the case in which at least the conductive material connecting portion 16A of the connection terminal 16 is not provided on the facing portion 12e facing the main body portion 12a of the adjacent DSC 50. As a result, it is possible to sufficiently prevent the short circuit between the adjacent DSCs 50.

In addition, in the DSC module 100, both of the conductive material connecting portion 16A and the conductive material non-connecting portion 16B are disposed along the sealing portion 30A. For this reason, it is possible to save the space required for the connection terminal 16 compared to the case of disposing the conductive material connecting portion 16A and the conductive material non-connecting portion 16B along the direction away from the sealing portion 30A.

Furthermore, in the DSC module 100, the width P of the adhesive portion of the surface on the transparent conductive substrate 15 side of the counter electrode 20 and the partitioning portion 31b of the first integrated sealing portion 31 is narrower than the width Q of the adhesive portion of the surface on the transparent conductive substrate 15 side of the counter electrode 20 and the annular portion 31a of the first integrated sealing portion 31. For this reason, it is possible to more sufficiently improve the aperture ratio of the DSC module 100. In addition, in the DSC module 100, the adjacent first sealing portions 31A are integrated between the adjacent counter electrodes 20 and the adjacent second sealing portions 32A are integrated between the adjacent counter electrodes 20. Here, the sealing portion exposed to the atmosphere is in two places in between the adjacent DSCs 50 when the adjacent first sealing portions 31A are not integrated. In contrast to this, in the DSC module 100, the sealing portion exposed to the atmosphere is in one place in between the adjacent DSCs 50 since the adjacent first sealing portions 31A are integrated. In other words, the sealing portion exposed to the atmosphere is in only one place of the partitioning portion 31b in between the adjacent DSCs 50 since the first integrated sealing portion 31 is constituted by the annular portion 31a and the partitioning portion 31b. In addition, the penetration distance of moisture or the like from the atmosphere to the electrolyte 40 increases since the first sealing portions 31A are integrated. For this reason, it is possible to sufficiently reduce the amount of moisture or air penetrating from the outside of the DSC 50 in between the adjacent DSCs 50. In other words, it is possible to sufficiently improve the sealing ability of the DSC module 100. In addition, according to the DSC module 100, the adjacent first sealing portions 31A are integrated. For this reason, it is possible to secure a sufficient sealing width at the partitioning portion 31b even if the width P of the adhesive portion of the surface on the transparent conductive substrate 15 side of the counter electrode 20 and the partitioning portion 31b of the first integrated sealing portion 31 is narrower than the width Q of the adhesive portion of the surface on the transparent conductive substrate 15 side of the counter electrode 20 and the annular portion 31a of the first integrated sealing portion 31. In other words, according to the DSC module 100, it is possible to sufficiently increase the bonding strength between the first sealing portion 31A and the transparent conductive substrate 15 and the bonding strength between the first sealing portion 31A and the counter electrode 20 while improving the aperture ratio. As a result, it is possible to improve the aperture ratio as well as it is possible to sufficiently suppress the peeling of the first sealing portion 31A from the transparent conductive substrate 15 and the counter electrode 20 even if the electrolyte 40 expands and thus an excessive stress directed from the inner side to the outer side of the first sealing portion 31A is applied in the case of using the DSC module 100 under a high temperature and thus it is possible to exhibit excellent durability.

Furthermore, in the DSC module 100, the width R of the partitioning portion 31b of the first integrated sealing portion 31 with the counter electrode 20 is 100% or more and less than 200% of the width T of the annular portion 31a of the first integrated sealing portion 31. In this case, since the width of the partitioning portion 31b is 100% or more of the width T of the annular portion 31a in the partitioning portion 31b of the first integrated sealing portion 31, the penetration distance of moisture or the like from the atmosphere to the electrolyte 40 increases compared to a case in which the width R of the partitioning portion 31b is less than 100% of the width T of the annular portion 31a in the partitioning portion 31b of the first integrated sealing portion 31. For this reason, it is possible to more sufficiently suppress that the moisture penetrates from the outside through the partitioning portion 31b present between the adjacent DSCs 50. On the other hand, it is possible to more improve the aperture ratio compared to a case in which the width R of the partitioning portion 31b exceeds 200% of the width T of the annular portion 31a.

In addition, in the DSC module 100, the second sealing portion 32A is adhered to the first sealing portion 31A, and the edge portion 20a of the counter electrode 20 is sandwiched by the first sealing portion 31A and the second sealing portion 32A. For this reason, the peeling is sufficiently suppressed by the second sealing portion 32A even if the stress in the direction away from the working electrode 10 with respect to the counter electrode 20 is applied. In addition, since the partitioning portion 32b of the second integrated sealing portion 32 is adhered to the first sealing portion 31A through the gap S between the adjacent counter electrodes 20, it is reliably prevented that the counter electrodes 20 of the adjacent DSCs 50 come in contact with each other.

Further, it is preferable that the DSC module 100 be a dye-sensitized solar cell module for low illumination which is used in low illumination environment. In the case of use in the low illumination environment, since generated current is small, even when the current collector is present only at the outer side of the sealing portion 30A, an increase in resistance can be sufficiently prevented and thus more excellent conversion efficiency can be achieved.

Here, the low illumination environment indicates that an intensity of illumination is 20,000 lux or less, and it is more preferable that the DSC module 100 be used in the environment of 10,000 lux or less. Further, the dye-sensitized solar cell for low illumination indicates a solar cell in which the concentration of at least one of the redox couple included in the electrolyte 40 is 0.006 mol/liter or less.

Next, description will be made in detail on the working electrode 10, the current collector 19, the external connecting portion 18, the connecting portion 14, a photosensitizing dye, the counter electrode 20, the sealing portion 30A, the inorganic insulating material 33, the electrolyte 40, the conductive materials 60P and 60Q, and the back sheet 80.

(Working electrode)

The material constituting the transparent substrate 11 may be any transparent material, for example, and examples of such a transparent material may include glass such as borosilicate glass, soda lime glass, glass which is made of soda lime and whose iron component is less than that of ordinary soda lime glass, and quartz glass, polyethylene terephthalate (PET), polyethylene naphthalate (PEN), polycarbonate (PC), and polyethersulfone (PES). The thickness of the transparent substrate 11 is appropriately determined depending on the size of the DSC module 100 and is not particularly limited, but it may be set into the range of from 50 to 10000 $\mu$m, for example.

Examples of the material contained in the transparent conductive film 12 may include a conductive metal oxide such as indium-tin-oxide (ITO), tin oxide ($SnO_2$), and fluorine-doped-tin-oxide (FTO). The transparent conductive film 12 may be constituted by a single layer or a laminate consisting of a plurality of layers containing different conductive metal oxides. It is preferable that the transparent conductive film 12 contain FTO since FTO exhibits high heat resistance and chemical resistance in a case in which the transparent conductive film 12 is constituted by a single layer. The transparent conductive film 12 may further contain a glass frit. The thickness of the transparent conductive film 12 may be set into the range of from 0.01 to 2 $\mu$m, for example.

In addition, the resistance value of the connecting portion 12g of the transparent conductive film 12D of the transparent conductive film 12 is not particularly limited but is preferably equal to or less than the resistance value represented by the following Equation (1).

$$\text{Resistance value} = \text{number of DSC 50 connected in series} \times 120\ \Omega \qquad (1)$$

In this case, it is possible to sufficiently suppress the deterioration of the performance of the DSC module 100 compared to a case in which the resistance value of the connecting portion 12g exceeds the resistance value represented by Equation (1) above. In the present embodiment, the number of DSCs 50 is 4 and thus the resistance value represented by Equation (1) above becomes 480 $\Omega$, and consequently, the resistance value of the connecting portion 12g is preferably 480 $\Omega$ or less.

The oxide semiconductor layer 13 is constituted by oxide semiconductor particles. The oxide semiconductor particles are constituted by, for example, titanium oxide ($TiO_2$), silicon oxide ($SiO_2$), zinc oxide (ZnO), tungsten oxide ($WO_3$), niobium oxide ($Nb_2O_5$), strontium titanate ($SrTiO_3$), tin oxide ($SnO_2$), indium oxide ($In_3O_3$), zirconium oxide ($ZrO_2$), thallium oxide ($Ta_2O_5$), lanthanum oxide ($La_2O_3$), yttrium oxide ($Y_2O_3$), holmium oxide ($Ho_2O_3$), bismuth oxide ($Bi_2O_3$), cerium oxide ($CeO_2$), aluminum oxide ($Al_2O_3$), or two or more kinds of these.

The oxide semiconductor layer 13 is usually constituted by an absorbing layer for absorbing light, but may be constituted by an absorbing layer and a reflective layer to return the light that is transmitted through the absorbing layer to the absorbing layer by reflecting the light.

The thickness of the oxide semiconductor layer 13 may be set to from 0.5 to 50 $\mu$m, for example.

(Current Collector)

The connection terminal 16 and the current collecting wire 17 serving as the current collector 19 contain a metal material. Examples of the metal material include silver, copper, and indium. They may be used singly or in combination of two or more kinds.

In addition, the connection terminal 16 may be constituted by the same material as or a different material from the conductive material 60P but it is preferable to be constituted by the same material.

In this case, it is possible to more sufficiently improve the adhesive property between the connection terminal 16 and the conductive material 60P since the connection terminal 16 and the conductive material 60P are constituted by the same material. For this reason, it is possible to more improve the connection reliability of the DSC module 100.

In the connection terminal 16, the width of the conductive material non-connecting portion 16B is not particularly limited as long as it is narrower than the width of the conductive material connecting portion 16A, but it is preferable to be equal to or less than 1/2 of the width of the conductive material connecting portion 16A.

In this case, it is possible to more improve the connection reliability of the DSC module 100 compared to a case in which the width of the conductive material non-connecting portion 16B exceeds 1/2 of the width of the conductive material connecting portion 16A.

The width of the conductive material connecting portion 16A is not particularly limited but is preferably from 0.5 to 5 mm and more preferably from 0.8 to 2 mm.

(External Connecting Portion)

The external connecting portion 18 contains a metal material. Examples of the metal material include silver, copper, and indium. They may be used singly or in combination of two or more kinds.

(Coupling portion)

The material constituting the coupling portion 14 is not particularly limited as long as it can make the adhesive portion 91 and the transparent conductive film 12 adhere to each other, and it is possible to use, for example, a glass frit, a resin material which is the same as the resin material used for the sealing portion 31A, or the like as the material constituting the coupling portion 14. Among them, the coupling portion 14 is preferably a glass frit. It is possible to effectively suppress the penetration of moisture or the like from the outside of the back sheet 80 or the adhesive portion 91 since the glass frit exhibits higher sealing ability than the resin material.

(Photosensitizing Dye)

Examples of the photosensitizing dye include ruthenium complexes containing a ligand including a bipyridine structure, a terpyridine structure or the like; and organic dyes such as porphyrin, eosin, rhodamine, and merocyanine. When the photosensitizing dye is used in the low illumination environment like indoor light, it is preferable to use a ruthenium complex containing a ligand including a bipyridine structure which can effectively absorb short wavelengths since the light wavelength of indoor light or the like slants to short wavelength side unlike sunlight.

(Counter Electrode)

As described above, the counter electrode 20 includes the metal substrate 21 and the conductive catalyst layer 22 that is provided on the metal substrate 21 at the working electrode 10 side and accelerates reduction reaction in the surface of the counter electrode 20. It is preferable that the counter electrode 20 have flexibility. In this case, even when stress, which is generated from the inside of the sealing portion 30A toward the sealing portion 30A, is generated, the counter electrode 20 can be deformed because of its flexibility, and some of stress can also be absorbed by the counter electrode 20. Therefore, breakage of the sealing portion 30A or release or the like between the first sealing portion 31A and the counter electrode 20 can be further suppressed.

The metal substrate 21 is constituted by, for example, a corrosion-resistant metallic material such as titanium, nickel, platinum, molybdenum, tungsten, aluminum, or stainless steel. The thickness of the metal substrate 21 is appropriately determined depending on the size of the DSC module 100 and is not particularly limited, but it may be set to from 0.005 to 0.1 mm, for example.

The catalyst layer 22 is constituted by platinum, a carbon-based material, or a conductive polymer. Here, a carbon nanotube is suitably used as the carbon-based material.

(Sealing portion)

The sealing portion 30A is constituted by the first sealing portion 31A and the second sealing portion 32A.

Examples of the material constituting the first sealing portion 31A may include a resin such as a modified polyolefin resin including an ionomer, an ethylene-vinyl acetic anhydride copolymer, an ethylene-methacrylic acid copolymer, an ethylene-vinyl alcohol copolymer and the like, an ultraviolet-cured resin, and vinyl alcohol polymer. The first sealing portion 31A may include an inorganic material such as glass, metal or the like.

The thickness of the first sealing portion 31A is usually from 40 to 90 $\mu$m and preferably from 60 to 80 $\mu$m.

The width P of the adhesive portion of the counter electrode 20 and the partitioning portion 31b is 25% or more and less than 100% of the width Q of the adhesive portion of the counter electrode 20 and the annular portion 31a of the first integrated sealing portion 31. In this case, it is possible to exhibit more excellent durability compared to a case in which the width P of the adhesive portion is less than 25% of the width Q of the adhesive portion. The width P of the adhesive portion is more preferably 30% or more and even more preferably 40% or more of the width Q of the adhesive portion.

In the DSC module 100, the width R of the partitioning portion 31b of the first integrated sealing portion 31 is preferably 100% or more and less than 200% and more preferably from 120 to 180% of the width T of the annular portion 31a of the first integrated sealing portion 31.

In this case, it is possible to balance a great aperture ratio and excellent durability.

Examples of the material constituting the second sealing portion 32A may include a resin such as a modified polyolefin resin including an ionomer, an ethylene-vinyl acetic anhydride copolymer, an ethylene-methacrylic acid copolymer, an ethylene-vinyl alcohol copolymer and the like, an ultraviolet-cured resin, and vinyl alcohol polymer in the same manner as the first sealing portion 31A. The second sealing portion 32A may include an inorganic material such as glass, metal or the like.

It is preferable that the second sealing portion 32A be formed by the same material as the first sealing portion 31A. In this case, since the first sealing portion 31A and the second sealing portion 32A are firmly adhered to each other and the interface between the first sealing portion 31A and the second sealing portion 32A can be eliminated, leakage of the electrolyte from the interface or penetration of moisture from the outside can be prevented.

The thickness of the main body portion 32e of the second sealing portion 32A is typically 20 to 40 $\mu$m, and preferably 30 to 40 $\mu$m. Meanwhile, it is sufficient that the thickness of the protruding portion 32d is thicker than that of the main body portion 32e, but the thickness thereof is typically 40 to 150 $\mu$m, and preferably 50 to 120 $\mu$m. Further, a difference between the thickness of the protruding portion 32d and the thickness of the main body portion 32e is preferably 20 to 100 $\mu$m.

(Insulating Material)

As a material constituting the inorganic insulating material 33, a glass frit and the like are exemplified. The thickness of the inorganic insulating material 33 is typically 10 to 100 $\mu$m, and preferably 15 to 50 $\mu$m.

(Electrolyte)

The electrolyte 40 contains, for example, a redox couple such as $I^-/I_3^-$ and an organic solvent. It is possible to use acetonitrile, methoxy acetonitrile, methoxy propionitrile, propionitrile, ethylene carbonate, propylene carbonate, diethyl carbonate, $\gamma$-butyrolactone, valeronitrile, pivalonitrile, glutaronitrile, methacrylonitrile, isobutyronitrile, phenyl acetonitrile, acrylonitrile, succinonitrile, oxalonitrile, pentanenitrile, and adiponitrile as the organic solvent. Examples of the redox couple may include a redox couple such as bromine/bromide ion, a zinc complex, an iron complex, and a cobalt complex in addition to $I^-/I_3^-$. In addition, the electrolyte 40 may use an ionic liquid instead of the organic solvent. As the ionic liquid, it is possible to use, for example, an ordinary temperature molten salt which is a known iodine salt, such as a pyridinium salt, an imidazolium salt, and a triazolium salt, and which is in a molten state at around room temperature. As such an ordinary temperature molten salt, it is possible to suitably use, for example, 1-hexyl-3-methylimidazolium iodide, 1-ethyl-3-propylimidazolium iodide, dimethylimidazolium iodide, ethylmethylimidazolium iodide, dimethylpropylimidazolium iodide, butylmethylimidazolium iodide, or methylpropylimidazolium iodide.

In addition, the electrolyte 40 may use a mixture of the ionic liquid above and the organic solvent above instead of the organic solvent above.

In addition, it is possible to add an additive to the electrolyte 40. Examples of the additive may include LiI, $I_2$, 4-t-butylpyridine, guanidinium thiocyanate, 1-methylbenzimidazole, and 1-butylbenzimidazole.

Moreover, as the electrolyte 40, a nanocomposite gel electrolyte which is a gel-like quasi-solid electrolyte obtained by kneading nanoparticles such as $SiO_2$, $TiO_2$, and carbon nanotubes with the electrolyte above may be used, or an electrolyte gelled using an organic gelling agent such as polyvinylidene fluoride, a polyethylene oxide derivative, and an amino acid derivative may also be used.

Incidentally, the electrolyte 40 includes a redox couple consisting of $I^-/I_3^-$, and the concentration of $I_3^-$ is preferably 0.006 mol/liter or less, more preferably 0 to $6 \times 10^{-6}$ mol/liter, and still more preferably 0 to $6 \times 10^{-8}$ mol/liter. In this case, since the concentration of $I_3^-$ that transports an electron is set to be low, leakage current can be further reduced. In particular, in the dye-sensitized solar cell for low illumination, since the generated current is lower, even when the concentration of $I_3^-$ that transports an electron is set to be low, the internal resistances between the counter electrode 20 and the electrolyte 40 and between the electrolyte 40 and the dye are not increased. When the concentration of $I_3^-$ is set to be low, leakage current can be further reduced. Therefore, since open circuit voltage can be further increased, the photoelectric conversion characteristics can be further improved.

(Conductive material)

As the conductive materials 60P and 60Q, for example, a metal film is used. It is possible to use, for example, silver or copper as the metallic material constituting the metal film.

(Back Sheet)

As described above, the back sheet 80 includes a main body portion including a weather resistant layer and a metal layer, and an adhesive layer provided on the surface of the main body portion at the DSC 50 side and adhered to the transparent conductive substrate 15.

The weather resistant layer may be constituted by, for example, polyethylene terephthalate or polybutylene terephthalate.

The thickness of the weather resistant layer may be from 50 to 300 $\mu$m, for example.

The metal layer may be constituted by, for example, a metallic material containing aluminum. The metallic material is usually constituted by aluminum simple substance but may be an alloy of aluminum and other metals. Examples of the other metals may include copper, manganese, zinc, magnesium, lead, and bismuth. Specifically, a 1000 series aluminum is desirable in which other metals are added to aluminum of 98% or higher purity in a trace quantity. This is because this 1000 series aluminum is inexpensive and excellent in workability compared to other aluminum alloys.

The thickness of the metal layer is not particularly limited but may be from 12 to 30 $\mu$m, for example.

The main body portion may further include a resin layer. Examples of the material constituting the resin layer may include a butyl rubber, a nitrile rubber, and a thermoplastic resin. These can be used singly or in combination of two or more kinds thereof. The resin layer may be formed on the entire surface on the side opposite to the weather resistant layer of the metal layer or may be formed only on the peripheral portion thereof.

Examples of the material constituting the adhesive layer may include a butyl rubber, a nitrile rubber, and a thermoplastic resin. These can be used singly or in combination of two or more kinds thereof.

The thickness of the adhesive layer is not particularly limited but may be from 300 to 1000 $\mu$m, for example.

The thickness of the adhesive part 91 is not particularly limited as long as the first distance H1 can be set to be larger than the second distance H2, but the thickness thereof is, for example, in a range of 100 to 1,000 $\mu$m.

A ratio (H1/H2) of the first distance H1 to the second distance H2 is preferably 1.1 to 15. In this case, as compared with a case where the ratio is out of the above-described range, the DSC 50 is less likely to receive the force from the outside, and thus the DSC 50 is less likely to be broken.

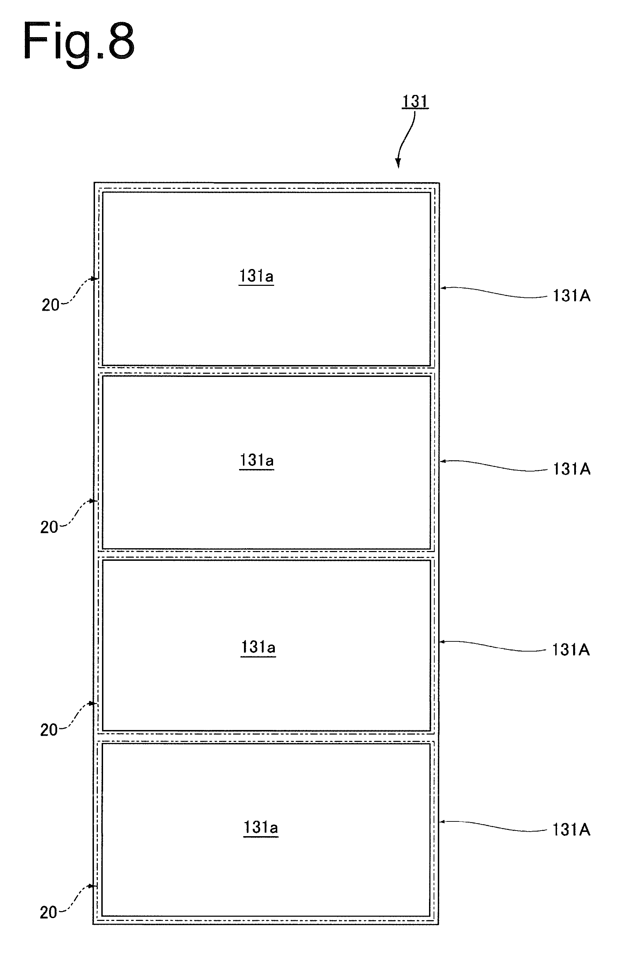

Next, the manufacturing method of the DSC module 100 will be described with reference to Fig. 3, Fig. 7 and Fig. 8. Fig. 8 is a plan view illustrating a first integrated sealing portion forming body used for forming the first integrated sealing portion of Fig. 4.

First, a laminate obtained by forming a transparent conductive film on one transparent substrate 11 is prepared.

As the method of forming the transparent conductive film, a sputtering method, a vapor deposition method, a spray pyrolysis deposition method (SPD), or a CVD method is used.

Next, as illustrated in Fig. 3, the groove 90 is formed with respect to the transparent conductive film, and the transparent conductive films 12A to 12F which are disposed in an insulated state to interpose the groove 90 between one another are formed. Specifically, the four transparent conductive films 12A to 12D corresponding to the DSCs 50A to 50D are formed so as to have the quadrangular-shaped main body portion 12a and the extending portion 12c. At this time, the transparent conductive films 12A to 12C corresponding to the DSCs 50A to 50C are formed such that the extending portion 12c has not only the projecting portion 12d but also the facing portion 12e which extends from the projecting portion 12d and faces the main body portion 12a of the adjacent DSC 50. In addition, the transparent conductive film 12D is formed so as to have not only the quadrangular-shaped main body portion 12a and the projecting portion 12d but also the first current extracting portion 12f and the connecting portion 12g connecting the first current extracting portion 12f and the main body portion 12a. At this time, the first current extracting portion 12f is formed so as to be disposed on the side opposite to the transparent conductive film 12B with respect to the transparent conductive film 12A. Moreover, the transparent conductive film 12E is formed so as to form the second current extracting portion 12h. At this time, the second current extracting portion 12h is formed so as to be disposed on the side opposite to the transparent conductive film 12B with respect to the transparent conductive film 12A and to be disposed next to the first current extracting portion 12f via the groove 90.

It is possible to form the groove 90 by, for example, a laser scribing method using a YAG laser, a $CO_2$ laser or the like as the light source.

In this manner, the transparent conductive substrate 15 obtained by forming a transparent conductive film 12 on the transparent substrate 11 is obtained.

Next, a precursor of the connection terminal 16 constituted by the conductive material connecting portion 16A and the conductive material non-connecting portion 16B is formed on the extending portion 12c of the transparent conductive films 12A to 12C. Specifically, the precursor of the connection terminal 16 is formed such that the conductive material connecting portion 16A is provided on the facing portion 12e. In addition, the precursor of the connection terminal 16 is also formed on the transparent conductive film 12E. In addition, the precursor of conductive material non-connecting portion 16B is formed so as to be narrower than the width of the conductive material connecting portion 16A. The precursor of the connection terminal 16 can be formed, for example, by coating and drying a silver paste.

Moreover, a precursor of the current collecting wiring 17 is formed on the connecting portion 12g of the transparent conductive film 12D. The precursor of the current collecting wiring 17 can be formed, for example, by coating and drying a silver paste.

In addition, precursors of the external connection terminals 18a and 18b for extracting the current to the outside are respectively formed on the first current extracting portion 12f and the second current extracting portion 12h of the transparent conductive film 12A. The precursor of the external connection terminal can be formed, for example, by coating and drying a silver paste.

Furthermore, a precursor of the oxide semiconductor layer 13 is formed on the main body portion 12a of each of the transparent conductive films 12A to 12D. The precursor of the oxide semiconductor layer 13 can be formed by printing and then drying a paste for porous oxide semiconductor layer formation containing oxide semiconductor particles.

The paste for oxide semiconductor layer formation contains a resin such as polyethylene glycol and a solvent such as terpineol in addition to the oxide semiconductor particles.

It is possible to use, for example, a screen printing method, a doctor blading method, or a bar coating method as the printing method of the paste for oxide semiconductor layer formation.

Further, a precursor of the inorganic insulating material 33 is formed in a region in which the first integrated sealing portion 31 is formed such that the precursor enters into the first groove 90A formed along the edge of the main body portion 12a and also covers the edge of the main body portion 12a. The inorganic insulating material 33 can be formed by, for example, applying a paste including a glass frit and drying the paste.

Further, in order to fix the back sheet 80, a precursor of the annular connecting portion 14 is formed, in the same manner as in the inorganic insulating material 33, in a region in which the adhesive part 91 is formed such that the precursor surrounds the inorganic insulating material 33 and passes through the transparent conductive film 12D, the transparent conductive film 12E, and the transparent conductive film 12F.

Finally, the precursor of the connection terminal 16, the precursor of the current collecting wiring 17, the precursor of the external connecting portion 18, the precursor of the inorganic insulating material 33, the precursor of the connecting portion 14, and the precursor of the oxide semiconductor layer 13 are collectively calcined to form the connection terminal 16, the current collecting wiring 17, the external connecting portion 18, the inorganic insulating material 33, the connecting portion 14, and the oxide semiconductor layer 13.

At this time, the firing temperature varies depending on the kind of the oxide semiconductor particles or the glass frit but is usually from 350 to 600°C, and the firing time also varies depending on the kind of the oxide semiconductor particles or the glass frit but is usually from 1 to 5 hours.

In this manner, the working electrode 10 is obtained in which the coupling portion 14 for fixing the back sheet 80 is formed.

Next, the photosensitizing dye is supported on the oxide semiconductor layer 13 of the working electrode 10. For this, the photosensitizing dye is adsorbed on the oxide semiconductor layer 13 by immersing the working electrode 10 in a solution containing the photosensitizing dye, the extra photosensitizing dye is then washed out with the solvent component of the above solution, and drying is performed. Thus, the photosensitizing dye may be adsorbed on the oxide semiconductor layer 13. However, it is also possible to support the photosensitizing dye on the oxide semiconductor layer 13 by coating a solution containing the photosensitizer dye on the oxide semiconductor layer 13 and then drying to adsorb the photosensitizing dye on the oxide semiconductor layer 13.

Next, the electrolyte 40 is disposed on the oxide semiconductor layer 13.

Next, as illustrated in Fig. 8, a first integrated sealing portion forming body 131 for forming the first integrated sealing portion 31 is prepared. The first integrated sealing portion forming body 131 can be obtained by preparing one sheet of resin film for sealing composed of the material constituting the first integrated sealing portion 31 and forming a quadrangular-shaped opening 131a as many as the number of the DSCs 50 in the resin film for sealing. The first integrated sealing portion forming body 131 has a structure obtained by integrating a plurality of first sealing portion forming bodies 131A.

Thereafter, this first integrated sealing portion forming body 131 is adhered on the working electrode 10. At this time, the first integrated sealing portion forming body 131 is adhered to the working electrode 10 so as to be superimposed on the inorganic insulating material 33. The adhesion of the first integrated sealing portion forming body 131 to the working electrode 10 can be performed by heating the first integrated sealing portion forming body 131 to melt. In addition, the first integrated sealing portion forming body 131 is adhered to the working electrode 10 such that the main body portion 12a of the transparent conductive film 12 is disposed on the inner side of the first integrated sealing portion forming body 131.

Meanwhile, the counter electrodes 20 are prepared to have the same number as the number of the DSCs 50.

The counter electrode 20 can be obtained by forming the conductive catalyst layer 22 which promotes the reduction reaction on the surface of the counter electrode 20 on the metal substrate 21.

Next, one more piece of the first integrated sealing portion forming body 131 described above is prepared. Thereafter, each of the plural counter electrodes 20 is bonded so as to close each of the openings 131a of the first integrated sealing portion forming body 131.

Next, the first integrated sealing portion forming body 131 adhered to the counter electrode 20 and the first integrated sealing portion forming body 131 adhered to the working electrode 10 are superimposed and melted by heating while applying a pressure to the first integrated sealing portion forming body 131. In this manner, the first integrated sealing portion 31 is formed between the working electrode 10 and the counter electrode 20. At this time, the first integrated sealing portion 31 is formed such that the width P of the adhesive portion of the surface on the transparent conductive substrate 15 side of the counter electrode 20 and the partitioning portion 31b of the first integrated sealing portion 31 is narrower than the width Q of the adhesive portion of the surface on the transparent conductive substrate 15 side of the counter electrode 20 and the annular portion 31a of the first integrated sealing portion 31. In addition, the first integrated sealing portion 31 is formed such that the width R of the partitioning portion 31b of the first integrated sealing portion 31 is 100% or more and less than 200% of the width T of the annular portion 31a of the first integrated sealing portion 31. The formation of the first integrated sealing portion 31 may be performed under the atmospheric pressure or reduced pressure, but it is preferable to be performed under reduced pressure.

Next, the second integrated sealing portion 32 is prepared (see Fig. 5). The second integrated sealing portion 32 has a structure obtained by integrating a plurality of the second sealing portions 32A. The second integrated sealing portion 32 can be obtained by preparing one sheet of resin film for sealing and forming a quadrangular-shaped inner opening 32c as many as the number of the DSCs 50 in the resin film for sealing. The second integrated sealing portion 32 is bonded to the counter electrode 20 so as to sandwich the edge portion 20a of the counter electrode 20 together with the first integrated sealing portion 31. The adhesion of the second integrated sealing portion 32 to the counter electrode 20 can be performed by heating the second integrated sealing portion 32 to melt.

The protruding portion 32d can be formed by providing concavity and convexity, in advance, in a heating jig, which is pressed against the second integrated sealing portion 32, in order to transfer heat when the second integrated sealing portion 32 is heated and melted, and pressing the concave portion against a portion in which the protruding portion 32d is desired to be formed.

As the resin film for sealing, a modified polyolefin resin containing an ionomer, an ethylene-anhydrous vinyl acetate copolymer, an ethylene-methacrylic acid copolymer, or an ethylene-vinyl alcohol copolymer, an ultraviolet-cured resin, and a resin of a vinyl alcohol polymer or the like are exemplified. The constituent material of the resin film for sealing used for forming the second integrated sealing portion 32 is preferably the same material as the constituent material of the resin film for sealing used for forming the first integrated sealing portion 31. In this case, since the first sealing portion 31A and the second sealing portion 32A are firmly adhered to each other and the interface between the first sealing portion 31A and the second sealing portion 32A can be eliminated, leakage of the electrolyte from the interface or penetration of moisture from the outside can be prevented.

Next, the bypass diodes 70A, 70B, and 70C are fixed to the partitioning portion 32b of the second sealing portion 32. In addition, the bypass diode 70D is fixed on the sealing portion 30A of the DSC 50D as well.

Thereafter, the conductive material 60Q is fixed to the metal substrate 21 of the counter electrode 20 of the DSCs 50B and 50C so as to pass through the bypass diodes 70A to 70D. Moreover, the conductive material 60P is formed such that each of the conductive materials 60Q between the bypass diodes 70A and 70B, between the bypass diodes 70B and 70C, and between the bypass diodes 70C and 70D is connected with the conductive material connecting portion 16A on the transparent conductive film 12A, the conductive material connecting portion 16A on the transparent conductive film 12B, and the conductive material connecting portion 16A on the transparent conductive film 12C, respectively. In addition, the conductive material 60P is fixed to the metal substrate 21 of the counter electrode 20 of the DSC 50A so as to connect the conductive material connecting portion 16A on the transparent conductive film 12E and the bypass diode 70A. Moreover, the transparent conductive film 12D and the bypass diode 70A are connected by the conductive material 60P.

At this time, with regard to the conductive material 60P, a paste containing a metallic material constituting the conductive material 60P is prepared, and this paste is coated from the counter electrode 20 over the conductive material connecting portion 16A of the connection terminal 16 of the adjacent DSC 50 and cured. With regard to the conductive material 60Q, a paste containing a metallic material constituting the conductive material 60Q is prepared, and this paste is coated on each of the counter electrodes 20 so as to link the adjacent bypass diodes and cured. At this time, as the paste above, it is preferable to use a low-temperature curing paste which is capable of being cured at a temperature of 90°C or less from the viewpoint of avoiding an adverse effect on the photosensitizing dye.

Finally, the back sheet 80 is prepared. Then, the peripheral edge 80a of the back sheet 80 is adhered to the annular region 14a of the connecting portion 14 with the adhesive part 91 interposed therebetween. At this time, the peripheral edge 80a of the back sheet 80 is adhered to the annular region 14a of the connecting portion 14 with the adhesive part 91 interposed therebetween such that the adhesive part 91 and the sealing portion 30A of the DSC 50 are separated from each other and the back sheet 80 and the counter electrode 20 are separated from each other. Further, at this time, the thickness of the adhesive part 91 is adjusted such that the first distance H1 can be set to be larger than the second distance H2.

The DSC module 100 is obtained in the manner described above.

Incidentally, in the above description, a method of collectively calcining the precursor of the connection terminal 16, the precursor of the current collecting wiring 17, the precursor of the external connecting portion 18, the precursor of the inorganic insulating material 33, the precursor of the connecting portion 14, and the precursor of the oxide semiconductor layer 13 is used in order to form the connection terminal 16, the current collecting wiring 17, the external connecting portion 18, the inorganic insulating material 33, the connecting portion 14, and the oxide semiconductor layer 13. However, the connection terminal 16, the current collecting wiring 17, the external connecting portion 18, the inorganic insulating material 33, the connecting portion 14, and the oxide semiconductor layer 13 may be formed by separately calcining the precursors thereof.

The invention is not limited to the above-described embodiment. For example, in the above-described embodiment, the first sealing portion 31A forms the first integrated sealing portion 31 by integrating the adjacent first sealing portions 31A, but the adjacent first sealing portions 31A may not be integrated. Similarly, the second sealing portions 32A are integrated between the adjacent counter electrodes 20 to form the second integrated sealing portion 32, but the second sealing portions 32A may not be integrated.

Further, in the above-described embodiment, the protruding portion 32d is provided in the region above the electrolyte 40, but may be provided in the region above the first sealing portion 31A. Even in this case, change in internal pressure or stress to be applied to the sealing portion 30A due to the external force can be also suppressed by the protruding portion 32d.

Further, in the above-described embodiment, the protruding portion 32d is provided over the entire circumference of the annular portion 32a as illustrated in Fig. 5, but may not be provided over the entire circumference. In this case, when the DSC 50 is rectangular in shape as in the above-described embodiment, it is preferable that the protruding portion 32d be provided at a position corresponding to at least the long side. When the DSC 50 is rectangular in shape, since the stress is more applied to the long side than the short side, the second sealing portion 32A provided at a position corresponding to the long side has the protruding portion 32d and thus the stress can be sufficiently alleviated.

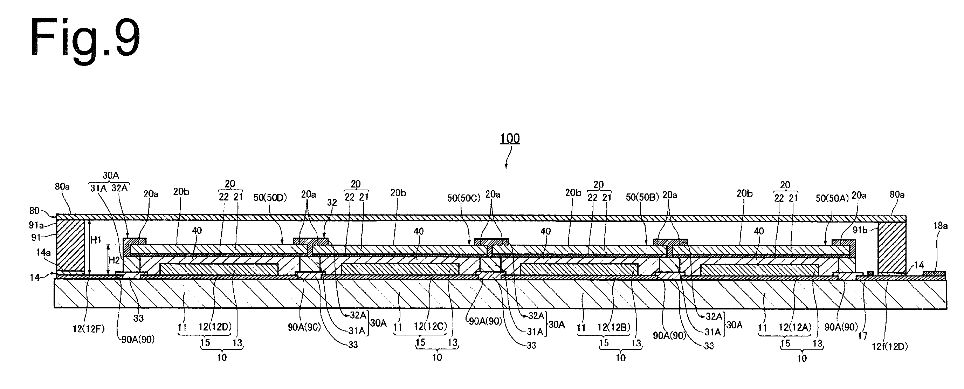

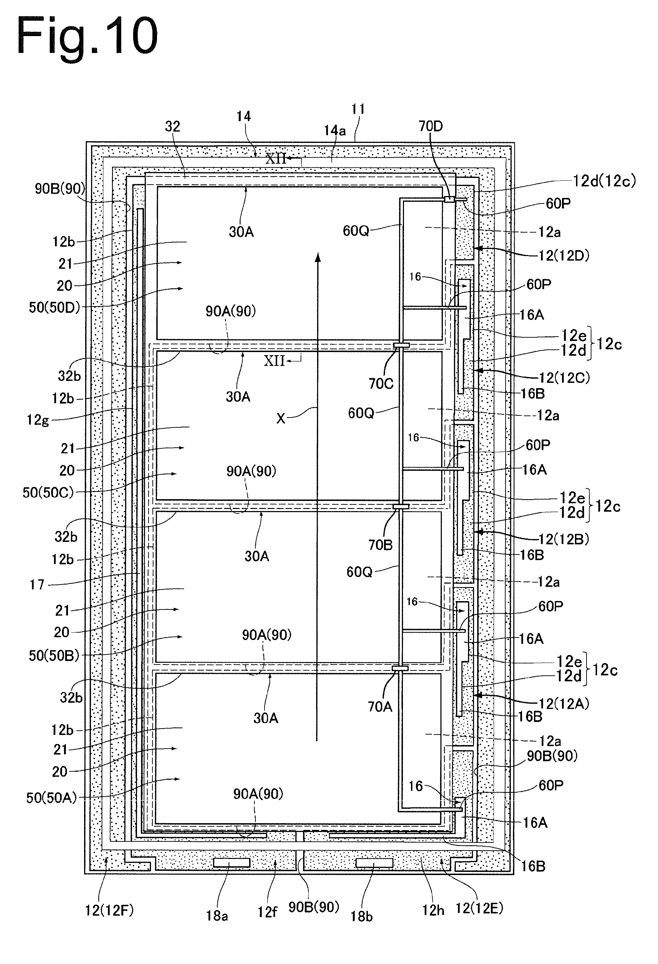

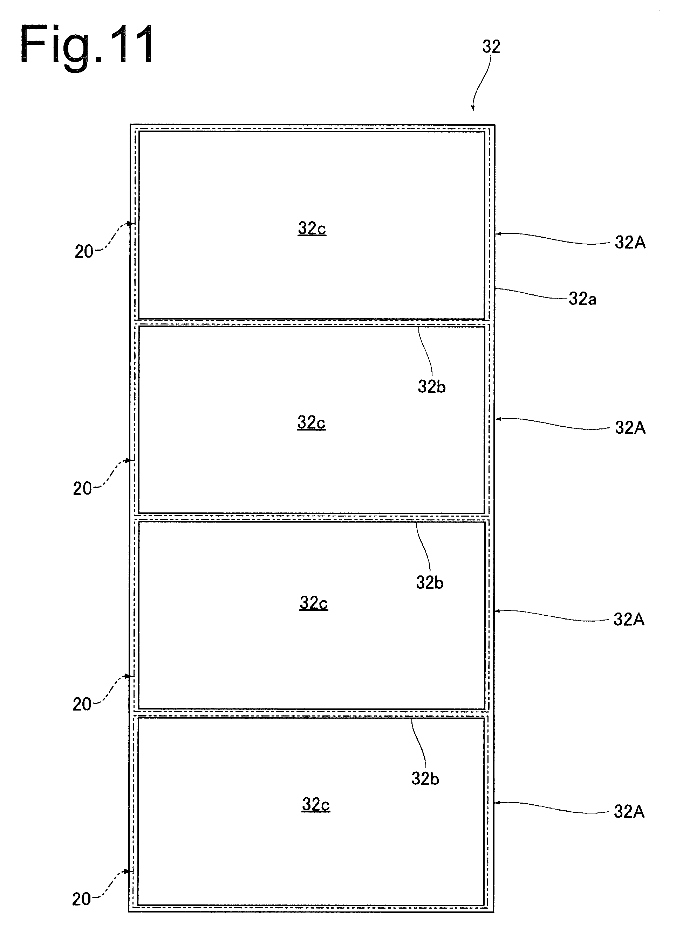

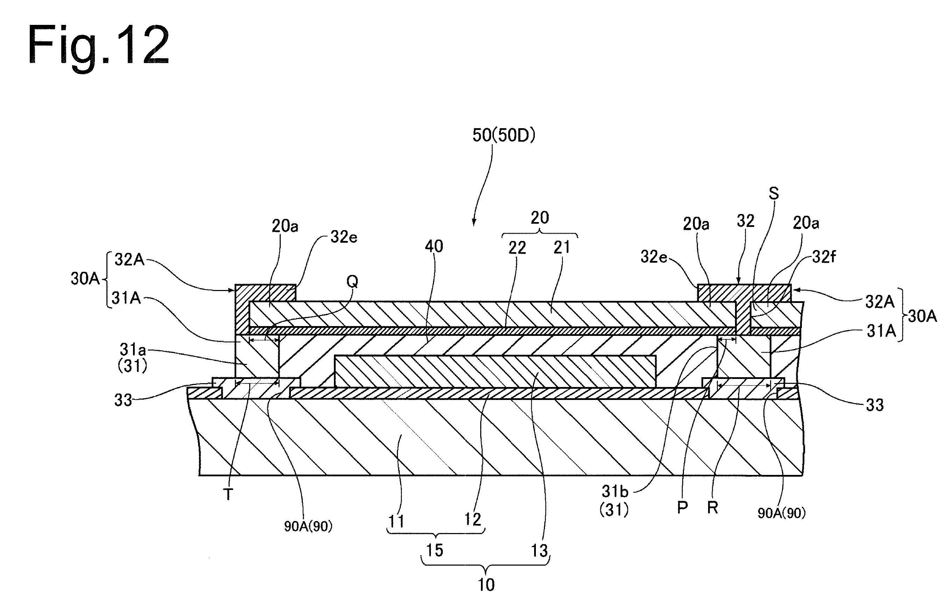

Further, the second integrated sealing portion 32 of the DSC module 100 has the protruding portion 32d in the above-described embodiment, but as in a DSC module 200 illustrated in Fig. 9, the second integrated sealing portion 32 may not have the protruding portion 32d. That is, the second integrated sealing portion 32 may be configured only by the main body portion 32e (see Fig. 10 to Fig. 12).

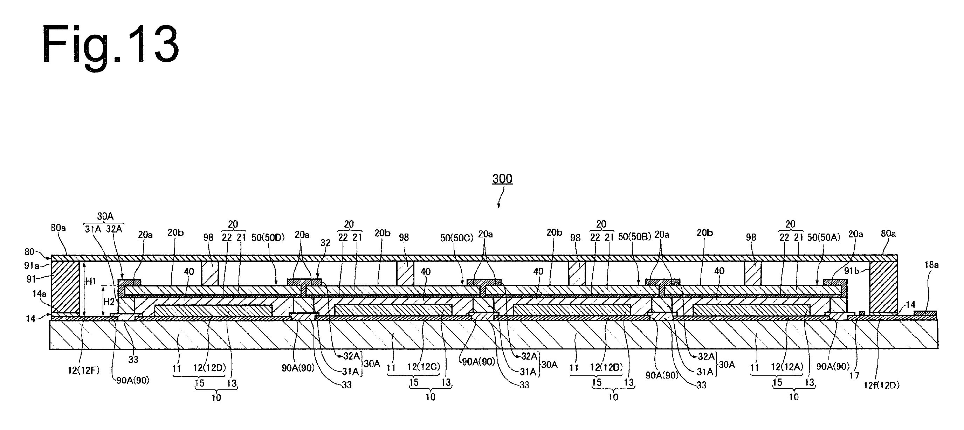

Further, the counter electrode 20 and the back sheet 80 are not connected by the adhesive material in the DSC module 200, but as in a DSC module 300 illustrated in Fig. 13, the counter electrode 20 and the back sheet 80 may be connected by an adhesive material 98.

According to the DSC module 300, since the counter electrode 20 and the back sheet 80 are connected by the adhesive material 98, the approach of the back sheet 80 to the counter electrode 20 is sufficiently suppressed by the adhesive material 98. Therefore, occurrence of short circuit between the DSCs 50 can be more sufficiently prevented. Further, since the counter electrode 20 and the back sheet 80 are connected by the adhesive material 98, when thermal expansion or thermal contraction occurs in a space formed by the back sheet 80, the DSC 50, and the adhesive part 91, the stress to be applied to the back sheet 80 is applied not only to the interface between the back sheet 80 and the adhesive part 91, but also to the interface between the back sheet 80 and the adhesive material 98. That is, it is sufficiently suppressed that the stress is concentrated in the interface between the back sheet 80 and the adhesive part 91. As a result, the stress to be applied to the interface between the back sheet 80 and the adhesive part 91 is sufficiently decreased and it is sufficiently suppressed that the back sheet 80 is released from the adhesive part 91. Therefore, the DSC module 300 can have more excellent durability.

The adhesive material 98 is not particularly limited as long as it can make the counter electrode 20 and the back sheet 80 adhere. Examples of such an adhesive material 98 include acrylic resin, urethane resin, epoxy resin, silicone resin, nitrile rubber, cellulose nitrate, phenolic resin, natural rubber, glue, and lacquer.

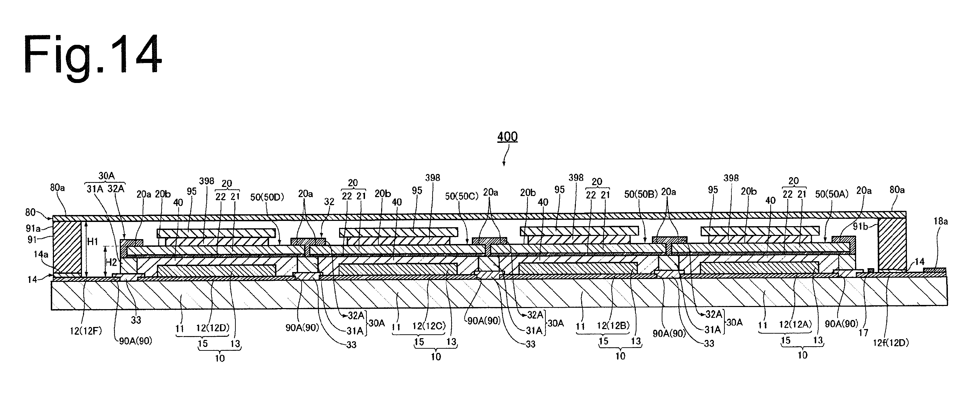

Further, the DSC module 200 does not further include a drying material to be adhered to the surface 20b of the counter electrode 20 at the back sheet 80 side, but as in a DSC module 400 illustrated in Fig. 14, a drying material 95 to be adhered to the surface 20b of the counter electrode 20 at the back sheet 80 side with an adhesive material 398 interposed therebetween may be provided. That is, the drying material 95 may be provided between the counter electrode 20 and the back sheet 80.

According to the DSC module 400, since moisture, which has been penetrated into a space formed by the back sheet 80, the DSC 50, and the adhesive part 91, is absorbed by the drying material 95, the moisture which is penetrated into the electrolyte 40 through the sealing portion 30A can be sufficiently reduced. Therefore, the DSC module 400 can have more excellent durability. Further, since the drying material 95 is provided between the counter electrode 20 and the back sheet 80, the drying material 95 does not also block incident light.

(Desiccant)

The drying material 95 may be in a sheet shape or granular. The drying material 95 may be one which absorbs moisture, for example, and examples of the drying material 95 may include silica gel, alumina, and zeolite.

In a case where the drying material 95 is sheet-shaped, the thickness of the drying material 95 is not particularly limited, but is preferably 0.1 to 5 mm. In this case, as compared with a case where the thickness of the drying material 95 is out of the above-described range, moisture can be absorbed more sufficiently. Even in a case where the back sheet 80 is stuck along the rear surface shape of each DSC 50, it can be more sufficiently suppressed that the back sheet 80 is torn.

The adhesive material 398 is not particularly limited as long as it can make the counter electrode 20 and the drying material 95 adhre. Examples of such an adhesive material 398 include acrylic resin, urethane resin, epoxy resin, silicone resin, nitrile rubber, cellulose nitrate, phenolic resin, natural rubber, glue, and lacquer.

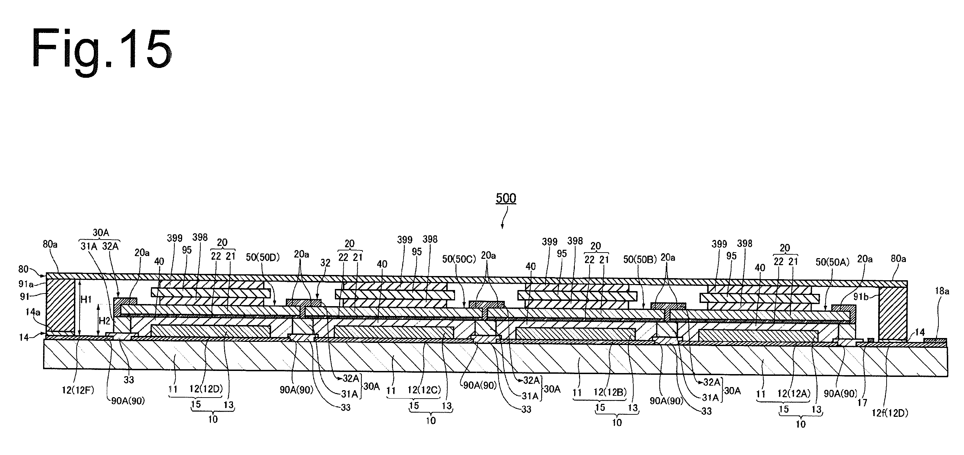

Further, the drying material 95 and the back sheet 80 are not connected to each other in the DSC module 200, but as in a DSC module 500 illustrated in Fig. 15, the drying material 95 and the back sheet 80 may be further connected to each other by an adhesive material 399.

According to the DSC module 500, the drying material 95 and the counter electrode 20 are connected to each other by the adhesive material 398, and as compared with a case where the drying material 95 and the back sheet 80 are not connected to each other by the adhesive material 399, it is possible to more sufficiently suppress the positional deviation of the drying material 95 with respect to each DSC 50 and the release of the drying material 95 from each DSC 50. For this reason, the effect of absorbing moisture which has been penetrated into a space formed by the back sheet 80, the DSC 50, and the adhesive part 91 is less likely to vary. As a result, the DSC module 500 can stably have more excellent durability.

The adhesive material 399 is not particularly limited as long as it can make the drying material 95 and the back sheet 80 adhere. As such an adhesive material 399, for example, acrylic resin, urethane resin, epoxy resin, silicone resin, nitrile rubber, cellulose nitrate, phenolic resin, natural rubber, glue, lacquer, and the like can be used. Incidentally, in the above-described embodiment, it is preferable that an oxygen absorbing material be provided between the back sheet 80 and the transparent conductive substrate 15. In this case, oxygen is sufficiently absorbed by the oxygen absorbing material. For this reason, an amount of oxygen to be exposed to the adhesive part 91 is sufficiently reduced. As a result, deterioration of the adhesive part 91 is sufficiently suppressed and thus the lifetime of the adhesive part 91 can be extended. In other words, more excellent durability can be imparted to the DSC modules 300 to 500.

The oxygen absorbing material may be disposed at any position as long as the position is present between the back sheet 80 and the transparent conductive substrate 15, but it is preferable that the oxygen absorbing material be provided on the inner surface of the back sheet 80. Further, in the case of using an oxygen absorbing agent, it is preferable that the drying material 95 also be used.

The oxygen absorbing material is not particularly limited as long as it can absorb oxygen. Examples of the oxygen absorbing material include ferrous carbonate, sodium chloride, and activated carbon. They can be used singly or in combination of two or more kinds.

Further, in the above-described embodiment, although the second sealing portion 32A is provided on the first sealing portion 31A, the second sealing portion 32A may cover the side surface of the first sealing portion 31A and be adhered to the inorganic insulating material 33, or may further cover the side surface of the inorganic insulating material 33 and be adhered to the transparent conductive substrate 15, as long as the second sealing portion 32A is adhered to the first sealing portion 31A.

Further, in the above-described embodiment, the first distance H1 is larger than the second distance H2. This is a necessary condition from the viewpoint of solving the second object described above, but this condition is not necessarily required from the viewpoint of solving the first object described above. That is, the first distance H1 may be equal to or less than the second distance H2.

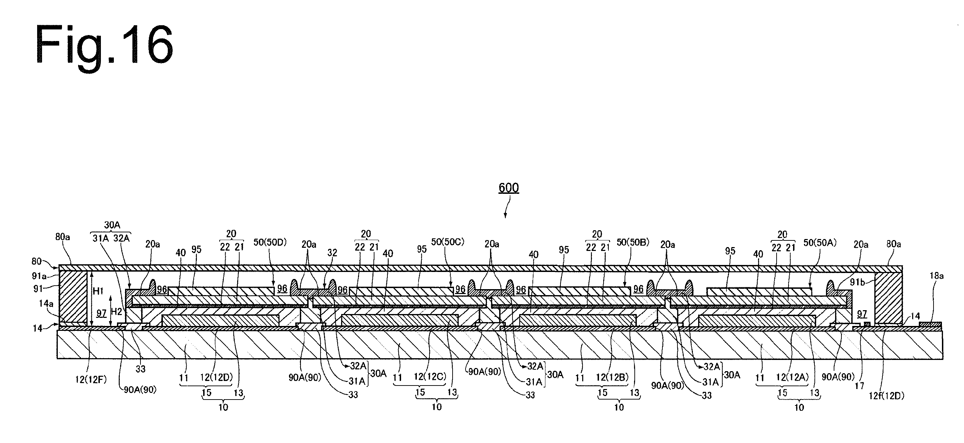

Further, the drying material 95 is not provided between the counter electrode 20 of the DSC 50 and the back sheet 80 in the DSC module 100, but as in a DSC module 600 illustrated in Fig. 16, the drying material 95 may be provided between the counter electrode 20 of the DSC 50 and the back sheet 80 such that the drying material 95 is in contact with the counter electrode 20. In this case, the drying material 95 may be provided between the counter electrode 20 of at least one DSC 50 of all DSCs 50 and the back sheet 80, but it is preferable that the drying material 95 be provided between the counter electrode 20 of each of all DSCs 50 and the back sheet 80.

Specifically, the drying material 95 is provided on the surface, which is opposite to the working electrode 10, of the counter electrode 20, that is, on the surface of the counter electrode 20 at the back sheet 80 side to protrude toward the back sheet 80. Furthermore, a first space 96 is formed between the back sheet 80 and an outer region 20c of the counter electrode 20 with respect to the interface 20b between the drying material 95 and the counter electrode 20 such that the first space 96 is in contact with the outer region 20c and the drying material 95. Here, the interface 20b has an area smaller than the surface of the counter electrode 20 at the back sheet 80 side, that is, the surface opposite to the transparent conductive substrate 15. Moreover, in this embodiment, the first space 96 is formed between the drying material 95 and the second sealing portion 32A. For this reason, moisture, which is penetrated from the outer side of the back sheet 80 into the DSC 50 side through the back sheet 80, is likely to be collected in the first space 96. Here, since the first space 96 is formed to be in contact with the drying material 95, the moisture collected in the first space 96 is absorbed by the drying material 95. As a result, since the moisture concentration in the first space 96 is low at all times, moisture is likely to collect in the first space 96. Further, the first space 96 is formed to be in contact with the outer region 20c of the counter electrode 20, and normally, moisture is less likely to be permeated to the counter electrode 20 as compared with the sealing portion 30A. For this reason, it is sufficiently suppressed that moisture is penetrated into the electrolyte 40 of the DSC 50. As a result, the DSC module 100 can have excellent durability.

Further, a second space 97 is formed between the sealing portion 30A and the back sheet 80, and this second space 97 is communicated with the first space 96. In this case, moisture may be penetrated from the outer side of the back sheet 80 into the second space 97 through the back sheet 80 in some cases. Since the second space 97 is formed between the back sheet 80 and the sealing portion 30A, when moisture is penetrated into the second space 97, normally, the moisture is easily penetrated into the electrolyte 40 through the sealing portion 30A. In this regard, in the DSC module 100, the second space 97 is communicated with the first space 96. Moreover, since the moisture collected in the first space 96 is absorbed by the drying material 95, the moisture concentration in the first space 96 is maintained in a low concentration state at all times. For this reason, the moisture collected in the second space 97 is likely to be diffused to the first space 96. Therefore, it is sufficiently suppressed that the moisture collected in the second space 97 is penetrated into the electrolyte 40 through the sealing portion 30A.

Further, in each DSC 50, the drying material 95 is fixed to the counter electrode 20. In this case, since the drying material 95 is fixed to the counter electrode 20, the positional deviation of the drying material 95 with respect to the counter electrode 20 is less likely to occur. Therefore, excellent durability can be stably achieved.

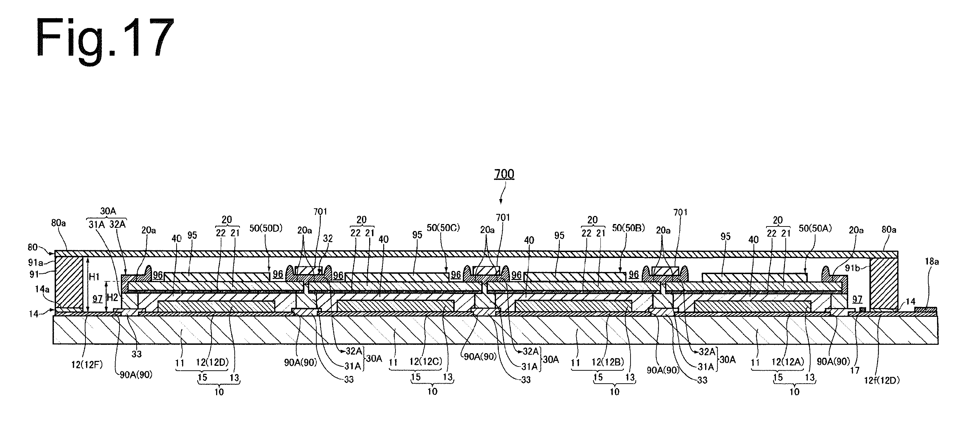

Further, the drying material 95 is provided only on the counter electrode 20 in the DSC module 600, but as in a DSC module 700 illustrated in Fig. 17, another drying material 701 may be provided across the counter electrodes 20 of the two adjacent DSCs 50.

When the counter electrodes 20 of the two adjacent DSCs 50 are separated from each other, the sealing portion 30A of the two adjacent DSCs 50 is likely to be exposed to moisture. In this regard, in a case where the counter electrodes 20 of the two adjacent DSCs 50 are separated from each other, when another drying material 701 is further provided across the counter electrodes 20 of the two adjacent DSCs 50, the moisture is sufficiently absorbed by the another drying material 701. For this reason, the sealing portion 30A is less likely to be exposed to moisture. As a result, it is sufficiently suppressed that moisture is penetrated into the electrolyte 40 through the sealing portion 30A. Therefore, this DSC module 700 can have excellent durability.

The material and the thickness of the drying material 701 are the same as those of the drying material 95.

Further, regarding the DSC modules 600 and 700, the drying material 95 is fixed to the counter electrode 20 in each DSC 50. However, the drying material 95 may be disposed on the counter electrode 20 and the drying material 95 is not necessarily fixed to the counter electrode 20.

Furthermore, regarding the DSC module 600, the drying materials 95 of each of the DSCs 50 are disposed to be separated to each other, but these drying materials 95 may be combined with each other to be formed as one drying material.

Further, in the DSC modules 600 and 700, the back sheet 80 is separated from the drying material 95, but the back sheet 80 may be in contact with the drying material 95 and the drying material 201. Even in this case, since the drying material 95 is provided to protrude toward the back sheet 80 side with respect to the counter electrode 20, the first space 96 can be formed between the outer region 20c of the counter electrode 20 and the back sheet 80.

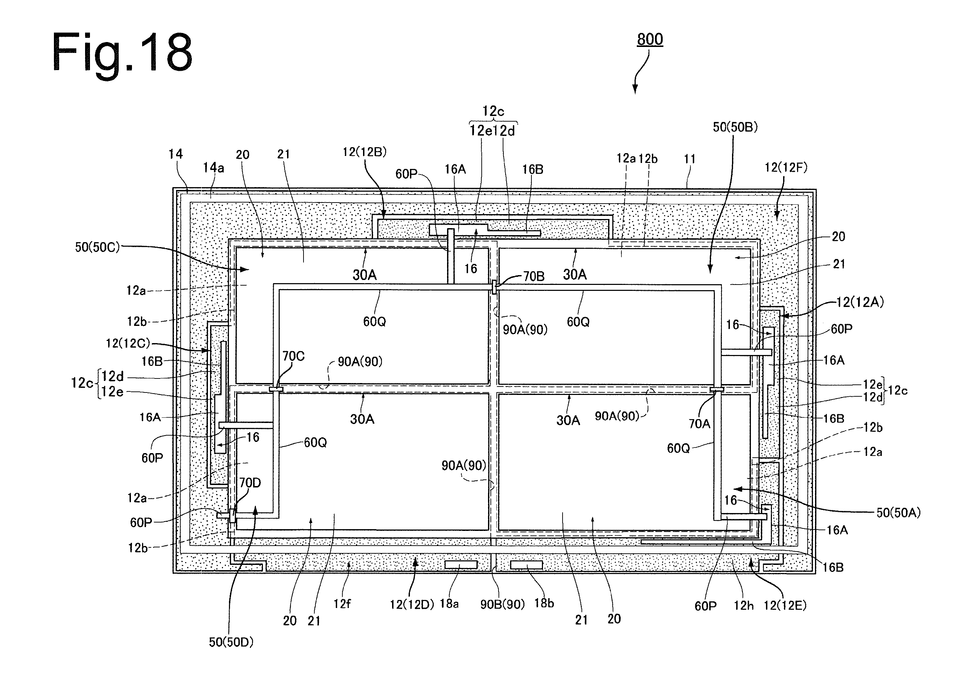

Further, in the above-described embodiment, both of the connection terminal 16 and the current collecting wiring 17 are provided as the current collector 19, but either one thereof may be provided. Furthermore, both of the connection terminal 16 and the current collecting wiring 17 may not be provided as long as anything else configuring the current collector 19 is provided. For example, as in a DSC module 800 illustrated in Fig. 18, in a case where the DSC 50C and the DSC 50D that are part of the DSC 50A to DSC 50D are folded back in the middle and the DSC 50A and DSC 50D are disposed to be adjacent to each other, unlike the DSC module 100, the transparent conductive film 12D need not be provided with the connection portion 12g between the main body portion 12a and the first current extracting portion 12f and there is also no need to provide the current collecting wiring 17.

Further, in the above-described embodiment, the current collector 19 is not provided between two adjacent DSCs 50, but the current collector 19 may be provided between two adjacent DSCs 50.

Further, in the above-described embodiment, the current collector 19 is provided at the inner side of the inner peripheral surface 91b of the adhesive part 91, but may not be provided at the inner side of the inner peripheral surface 91b of the adhesive part 91. That is, since it is sufficient that the current collector 19 is provided at the inner side of the outer peripheral surface 91a of the adhesive part 91, the current collector 19 may be provided between the adhesive part 91 and the transparent conductive film 12.

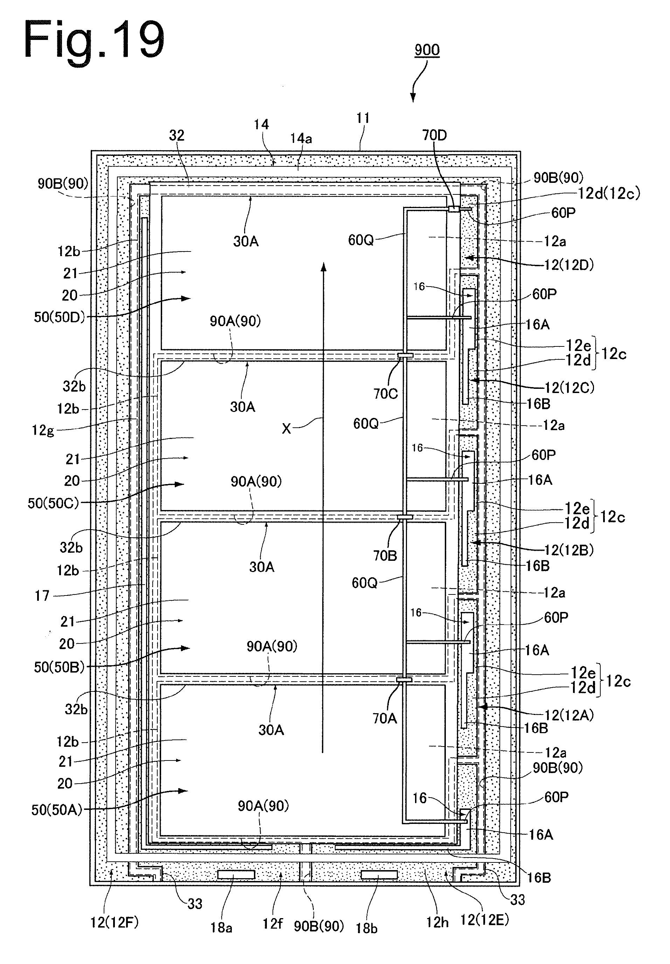

Further, the second groove 90B intersecting with the connecting portion 14 of the adhesive part 91 and the transparent conductive substrate 15 is not covered with the inorganic insulating material 33 in the above-described embodiment, but as in a DSC module 900 illustrated in Fig. 19, it is preferable that the second groove 90B be covered with the inorganic insulating material 33. Incidentally, the back sheet 80 is omitted in Fig. 19. As illustrated in Fig. 19, when the second groove 90B intersects with the connecting portion 14, moisture can be penetrated through this second groove 90B into a space formed by the back sheet 80, the DSC 50, and the adhesive part 91. In this case, the inorganic insulating material 33 enters into the second groove 90B and then the edge of the portion of the transparent conductive film 12 excluding the main body portion 12a is also covered with the inorganic insulating material 33. Therefore, it is sufficiently suppressed that the moisture is penetrated from the outer side of the back sheet 80 or the adhesive part 91 into the inner side thereof. Therefore, it is sufficiently suppressed that the moisture, which has been penetrated into the space formed by the back sheet 80, the DSC 50, and the adhesive part 91, enters into the inner side of the sealing portion 30A through the sealing portion 30A. Accordingly, a decrease in the durability of the DSC module 900 can be sufficiently suppressed.

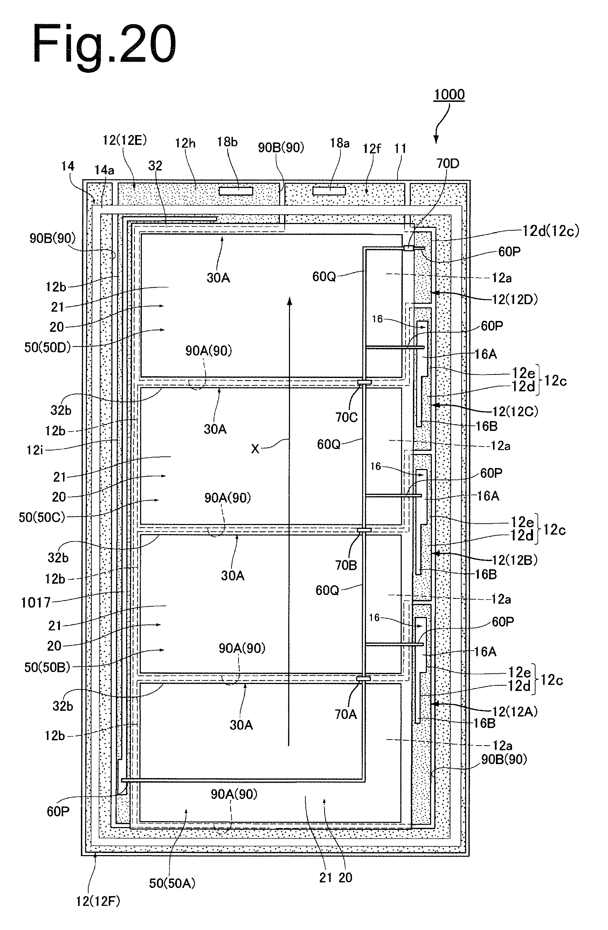

Furthermore, in the above embodiment, the first current extracting portion 12f and the second current extracting portion 12h are disposed in the vicinity on the DSC 50A side, but the first current extracting portion 12f and the second current extracting portion 12h may be disposed in the vicinity on the DSC 50D side as illustrated in a DSC module 1000 illustrated in Fig. 20. In this case, the first current extracting portion 12f is provided so as to protrude on the side opposite to the DSC 50C with respect to the main body portion 12a of the transparent conductive film 12D to the outer side of the sealing portion 30A. On the other hand, the second current extracting portion 12h is provided on the side opposite to the DSC 50C with respect to the main body portion 12a of the transparent conductive film 12D. In addition, the connecting portion 12i as a second connecting portion extends along the transparent conductive films 12A to 12D, and this connecting portion 12i connects the second current extracting portion 12h and the metal substrate 21 of the counter electrode 20 of the DSC 50A. Specifically, a current collecting wiring 1017 is provided on the connecting portion 12i along the connecting portion 12i, and this current collecting wiring 1017 is connected with the conductive material 60P extending from the bypass diode 70A. It is possible to achieve space saving while exhibiting excellent photoelectric conversion characteristics by this DSC module 1000 as well. Meanwhile, in this case, it is the same as the above embodiment that it is preferable that the resistance value of the connecting portion 12i be equal to or less than the resistance value represented by the following Equation (1). Resistance value = number of DSC 50 connected in series $\times$ 120 $\Omega$ (1)

Further, in the above-described embodiment, the external connecting portion 18 is provided, but the external connecting portion 18 may not be provided.

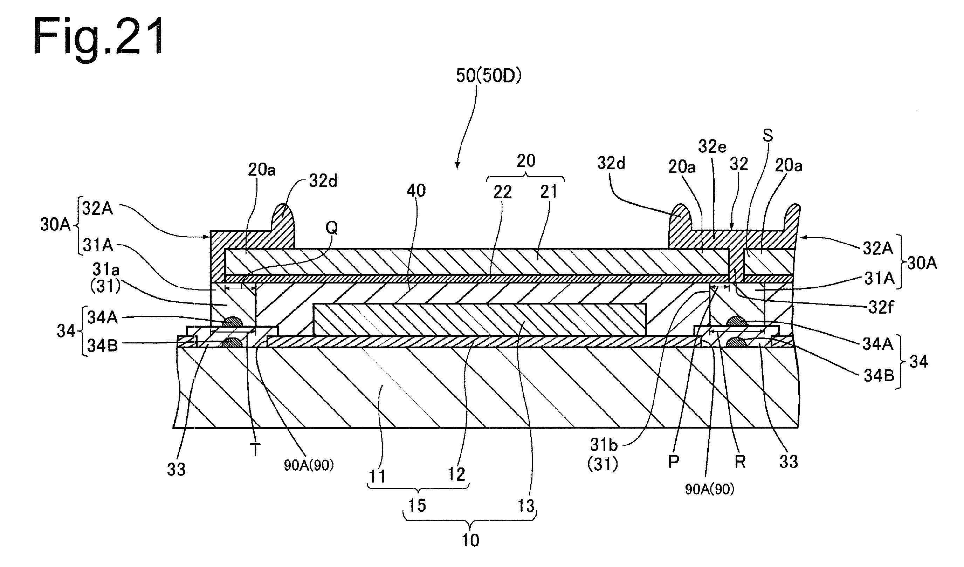

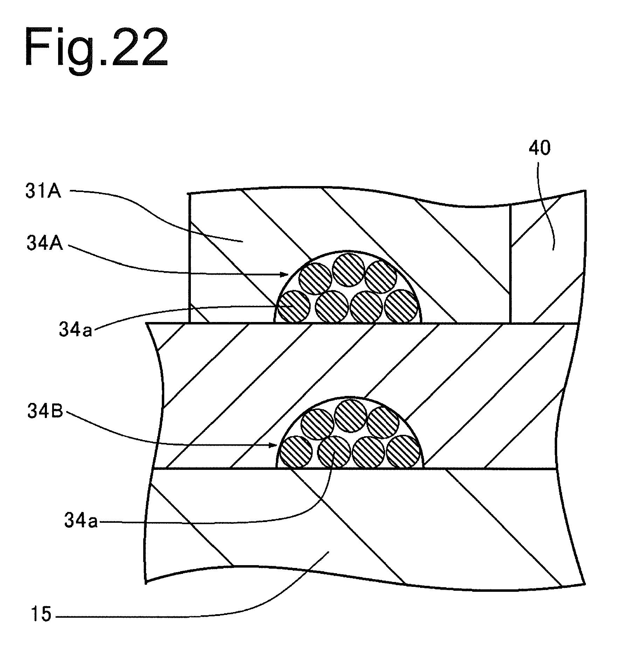

Further, in the above-described embodiment, it is preferable that a porous inorganic portion 34 be provided at a part between the first sealing portion 31A and the inorganic insulating material 33 and a part between the inorganic insulating material 33 and the transparent conductive substrate 15, as illustrated in Fig. 21. Here, the porous inorganic portion 34 has a first porous inorganic portion 34A provided between the first sealing portion 31A and the inorganic insulating material 33 and a second porous inorganic portion 34B provided at a part between the inorganic insulating material 33 and the transparent conductive substrate 15. The first porous inorganic portion 34A is enclosed in the first sealing portion 31A and the inorganic insulating material 33. On the other hand, the second porous inorganic portion 34B is enclosed in the inorganic insulating material 33 and the transparent conductive substrate 15. Specifically, as illustrated in Fig. 22, the first porous inorganic portion 34A and the second porous inorganic portion 34B each have a large number of inorganic particles 34a. The particles of a large number of inorganic particles 34a are superimposed with each other and stacked in a three-dimensional manner, and a gap between the particles of the inorganic particles 34a is formed, thereby forming a porous portion. The inorganic particles 34a may or may not be connected to each other. Further, the material at the circumference of the porous inorganic portion 34 does not enter into the inside of the porous portion of the porous inorganic portion 34. Furthermore, the porous inorganic portions 34 are present in a dot shape when the DSC module 100 is viewed in plan view, and are provided not to surround the entire circumference of the oxide semiconductor layer 13 (not illustrated), unlike the first sealing portion 31A or the inorganic insulating material 33.

In this case, in the DSC module 100, the porous inorganic portion 34 is provided at a part between the first sealing portion 30A and the inorganic insulating material 33 and a part between the inorganic insulating material 33 and the transparent conductive substrate 15. The inner stress is potentially applied between the first sealing portion 30A and the inorganic insulating material 33 and between the inorganic insulating material 33 and the transparent conductive substrate 15 depending on a difference in thermal expansion coefficients, but when the porous inorganic portion 34 is provided, the material at the circumference of the porous inorganic portion 34 is likely to flow, and thus the inner stress which is potentially applied can be alleviated. Therefore, the DSC module 100 can have more excellent durability.

As a material constituting the inorganic particles 34a of the porous inorganic portion 34, an oxide semiconductor, a glass frit, a metal, and the like are exemplified. As such particles of the oxide semiconductor, for example, titanium oxide ($TiO_2$), silicon oxide ($SiO_2$), zinc oxide ($ZnO$), tungsten oxide ($WO_3$), niobium oxide ($Nb_2O_5$), strontium titanate ($SrTiO_3$), tin oxide ($SnO_2$), indium oxide ($In_3O_3$), zirconium oxide ($ZrO_2$), thallium oxide ($Ta_2O_5$), lanthanum oxide ($La_2O_3$), yttrium oxide ($Y_2O_3$), holmium oxide ($Ho_2O_3$), bismuth oxide ($Bi_2O_3$), cerium oxide ($CeO_2$), aluminum oxide ($Al_2O_3$), or two or more kinds thereof are preferably used.

The thickness of the porous inorganic portion 34 is typically 0.5 to 20 $\mu$m, and preferably 2 to 10 $\mu$m. The width of the porous inorganic portion 34 is typically 1 to 50 $\mu$m. Further, the particle size of each of particles constituting the porous inorganic portion 34 is typically 10 to 600 nm, and preferably 20 to 400 nm. In this case, as compared with a case where the particle size is less than 10 nm, internal stress can be sufficiently alleviated. On the other hand, as compared with a case where the particle size is more than 600 nm, it is possible to sufficiently suppress that the electrolyte 40 is leaked or moisture is penetrated through gaps between particles.

Here, the second porous inorganic portion 34B can be formed as follows. That is, a precursor of the second porous inorganic portion 34B is formed in a dot shape on the transparent conductive substrate 15 and at the edge of the main body portion 12a and then this precursor is calcined, thereby forming the second porous inorganic portion 34B. The precursor of the second porous inorganic portion 34B can be formed, for example, by printing a paste for forming a porous inorganic portion layer containing inorganic particles and then drying the paste.

The paste for forming a porous inorganic portion contains a resin such as polyethylene glycol and a solvent such as terpineol, in addition to inorganic particles.

As a printing method of the paste for forming a porous inorganic portion, for example, a screen printing method, a doctor blade method, a bar coating method, or the like can be used.

Further, a precursor of the inorganic insulating material 33 is formed to cover the precursor of the second porous inorganic portion 34B, enter into the first groove 90A formed along the edge of the main body portion 12a, and also cover the edge of the main body portion 12a. The inorganic insulating material 33 can be formed by, for example, applying a paste containing a glass frit and drying the paste.

The first porous inorganic portion 34A can be formed in the same manner as in the second porous inorganic portion 34B.

Incidentally, the porous inorganic portion 34 may be configured only by any one of the first porous inorganic portion 34A and the second porous inorganic portion 34B.

Further, in the above-described embodiment, the counter electrode 20 has the metal substrate 21, but an insulating substrate and a conductive layer provided on the insulating substrate at the electrolyte side may be used instead of the metal substrate 21. As a material of the insulating substrate, the same material as the transparent substrate 11 can be used. Further, as a material of the conductive layer, the same material as the transparent conductive film 12 can be used. In this case, a plurality of DSCs 50 can be connected in series by allowing the counter electrode 20 to extend to the upper portion of the connection terminal 16 to connect the conductive layer of the counter electrode 20 and the connection terminal 16 by the conductive material 60P.

In addition, in the above embodiment, the groove 90 has the second groove 90B, but the second groove 90B may not be necessarily formed.

Further, in the above-described embodiment, the oxide semiconductor layer 13 is formed on the transparent conductive substrate 15, but may be formed on the metal substrate 21. In this case, the metal substrate 21 does not have the catalyst layer 22, and the catalyst layer 22 may be formed on the transparent conductive substrate 15.

In addition, in the above embodiment, the widths of the conductive material connecting portion 16A and the conductive material connecting portion 16B of the connection terminal 16 are set to be constant, but each of the widths of the conductive material connecting portion 16A and the conductive material connecting portion 16B may change along the extending direction of the connection terminal 16. For example, the width may monotonically increase from the end portion on the farthest side from the conductive material connecting portion 16A of the conductive material non-connecting portion 16B toward the end portion on the closest side thereof, and the width may monotonically increase from the end portion of the conductive material non-connecting portion 16B side of the conductive material connecting portion 16A toward the end portion on the farthest side from the conductive member non-connecting portion 16B.

In addition, in the above embodiment, the conductive material connecting portion 16A and the conductive material connecting portion 16B are provided along the sealing portion 30A, respectively, but these may be formed so as to extend in the direction away from the sealing portion 30A. However, in this case, it is preferable that the conductive material connecting portion 16A be disposed at the position closer to the sealing portion 30A than the conductive material non-connecting portion 16B. In this case, it is possible to more shorten the conductive material 60P.

Alternatively, in the connection terminal 16 formed on the transparent conductive films 12A to 12C, the conductive material non-connecting portion 16B may be disposed so as to be orthogonal to the conductive material connecting portion 16A.

Moreover, the width of the conductive material connecting portion 16A may be equal to or less than the width of the conductive material non-connecting portion 16B.

In addition, in the above embodiment, the second sealing portion 32A is adhered to the first sealing portion 31A, but the second sealing portion 32A may not be adhered to the first sealing portion 31A.

Furthermore, in the above embodiment, the sealing portion 30A is constituted by the first sealing portion 31A and the second sealing portion 32A, but the second sealing portion 32A may be omitted.

In addition, in the above embodiment, the width P of the adhesive portion of the counter electrode 20 and the partitioning portion 31b of the first integrated sealing portion 31 is narrower than the width Q of the adhesive portion of the counter electrode 20 and the annular portion 31a of the first integrated sealing portion 31, but the width P of the adhesive portion may be equal to or more than the width Q of the adhesive portion.

Furthermore, in the above embodiment, the width R of the partitioning portion 31b of the first integrated sealing portion 31 is 100% or more and less than 200% of the width T of the annular portion 31a of the first integrated sealing portion 31, but the width R of the partitioning portion 31b may be less than 100% or 200% or more of the width T of the annular portion 31a of the first integrated sealing portion 31.

Further, in the above-described embodiment, the adhesive part 91 and the transparent conductive film 12 are adhered to each other with the connecting portion 14 formed by a glass frit interposed therebetween, but it is not necessary to attach the adhesive part 91 and the transparent conductive film 12 to each other with the connecting portion 14 interposed therebetween.

Further, in the above-described embodiment, the connecting portion 14 and the inorganic insulating material 33 are separated from each other, but it is preferable that they all be configured by a glass frit and integrated with each other. In this case, even when moisture is penetrated into the space formed by the back sheet 80, the DSC 50, and the adhesive part 91, the interface between the connecting portion 14 and the transparent conductive substrate 15 and the interface between the sealing portion 30A and the transparent conductive substrate 15 are not present. Further, both of the inorganic insulating material 33 and the connecting portion 14 are also formed by an inorganic material, and have a higher sealing property than a resin. For this reason, it is possible to sufficiently suppress the penetration of moisture through the interface between the connecting portion 14 and the transparent conductive substrate 15 or the interface between the inorganic insulating material 33 and the transparent conductive substrate 15.

Further, in the above-described embodiment, the inorganic insulating material 33 is formed by an inorganic material, but the material constituting the inorganic insulating material 33 may be one having a higher melting point than the material constituting the first sealing portion 30A. For this reason, as such a material, a glass frit is exemplified. Further, an organic insulating material can also be used instead of the inorganic insulating material 33. Examples of such an organic insulating material include a thermosetting resin such as polyimide resin and a thermoplastic resin. Among them, a thermosetting resin is preferably used. In this case, even if the sealing portion 30A has fluidity at high temperature, the organic insulating material is less likely to flow even at high temperature similarly to the inorganic insulating material, as compared with the case of using a thermoplastic resin. For this reason, the contact of the transparent conductive substrate 15 and the counter electrode 20 is sufficiently suppressed, and thus the short circuit between the transparent conductive substrate 15 and the counter electrode 20 can be sufficiently suppressed.

Moreover, in the above embodiment, the plurality of DSCs 50 are connected in series but may be connected in parallel.

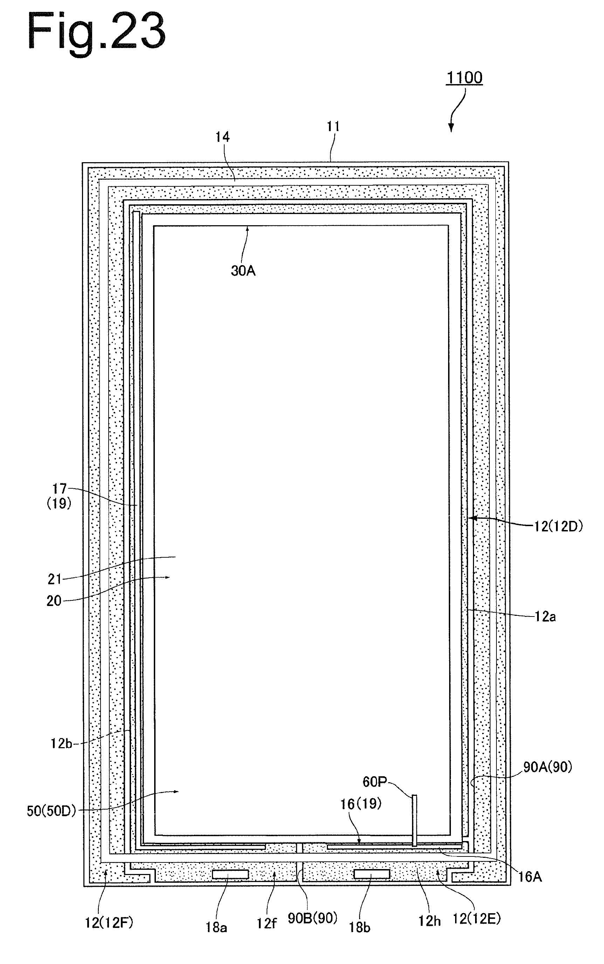

Further, the DSC module 100 has a plurality of DSCs 50 in the above-described embodiment, but as in a dye-sensitized solar cell element 1100 illustrated in Fig. 23, the DSC 50 may be one. In this case, the back sheet 80 may be provided to surround one DSC 50. Even in this case, it is preferable that the current collector 19 be provided at the outer side of the sealing portion 30A and the inner side of the outer peripheral surface 91a of the adhesive part 91.

Incidentally, in the dye-sensitized solar cell element 1100 illustrated in Fig. 23, the DSC 50A to the DSC 50C are omitted, and the connection terminal 16 provided on the second current extracting portion 12h and the metal substrate 21 of the counter electrode 20 of the DSC 50D are electrically connected to each other by the conductive material 60P. Further, in the dye-sensitized solar cell element 1100, the connection terminal 16 is configured only by the conductive material connecting portion 16A, and this conductive material connecting portion 16A is disposed between the sealing portion 30A and the connecting portion 14. That is, the conductive material connecting portion 16A is not disposed at the position facing the lateral edge 12b of the main body portion 12a of the transparent conductive film 12D of the DSC 50D. For this reason, the oxide semiconductor layer 13 can be enlarged to the space at the portion at which the conductive material connecting portion 16A has been disposed in the DSC module 100 of the first embodiment. In this case, it is possible to increase the area for power generation as well as to effectively utilize the wasted space.

Further, in the above-described embodiment, the number of the DSCs 50 is four, but in a case where the DSC 50 is provided in a plurality of number, the number of the DSCs 50 is not limited to four. In a case where a plurality of DSCs 50 are included in this way, it is more preferable that the DSCs 50 be arranged in a certain direction as illustrated in Fig. 2, rather than a case where some of the DSC 50A to the DSC 50D are folded back in the middle as illustrated in Fig. 18. In a case where the DSCs 50 are arranged in a certain direction in this way, it is possible to select any one of an even number and an odd number as the number of the DSCs 50 and thus the number of the DSCs 50 can be freely determined. Accordingly, the degree of freedom of the design can be improved.

In addition, in the above embodiment, the counter electrode 20 constitutes the counter substrate, but an insulating substrate may be used instead of the counter electrode 20 as a counter substrate. In this case, the structure constituted by the oxide semiconductor layer, the porous insulating layer, and the counter electrode is disposed in the space between the insulating substrate, the sealing portion 30A, and the transparent conductive substrate 15. The structure can be provided on the surface on the counter substrate side of the transparent conductive substrate 15. The structure is constituted by the oxide semiconductor layer, the porous insulating layer, and the counter electrode in order from the transparent conductive substrate 15 side. In addition, the electrolyte is disposed in the space above. The electrolyte is impregnated even into the inside of the oxide semiconductor layer and the porous insulating layer. Here, it is possible to use, for example, a glass substrate or a resin film as the insulating substrate. In addition, it is possible to use the same one as the counter electrode 20 of the above embodiment as the counter electrode. Alternatively, the counter electrode may be constituted by, for example, a porous single layer containing carbon or the like. The porous insulating layer is mainly provided in order to prevent the physical contact of the porous oxide semiconductor layer and the counter electrode and to impregnate the electrolyte thereinto. It is possible to use, for example, a fired body of an oxide as such a porous insulating layer.

EXAMPLES

Hereinafter, the content of the invention will be described more specifically with reference to Examples, but the invention is not limited to the following Examples.

(Example 1)

First, a laminate obtained by forming a transparent conductive film composed of FTO having a thickness of 1

μm on a transparent substrate which is composed of glass and has a thickness of 1 mm was prepared. Next, as illustrated in Fig. 3, the groove 90 was formed on the transparent conductive film 12 by a $CO_2$ laser (V-460 manufactured by Universal Laser Systems Inc.), and the transparent conductive films 12A to 12F were formed. At this time, the width of the groove 90 was set to 1 mm. In addition, each of the transparent conductive films 12A to 12C was formed so as to have the main body portion having a quadrangular shape of 4.6 cm x 2.0 cm and the extending portion protruding from the side edge portion of one side of the main body portion. In addition, the transparent conductive film 12D was formed so as to have the main body portion having a quadrangular shape of 4.6 cm x 2.1 cm and the extending portion protruding from the side edge portion of one side of the main body. In addition, the extending portion 12c of the three transparent conductive films 12A to 12C among the transparent conductive films 12A to 12D was constituted by the projecting portion 12d projecting from the one side edge portion 12b of the main body portion 12a and the facing portion 12e which was extended from the projecting portion 12d and faced the main body portion 12a of the adjacent transparent conductive film 12. In addition, the extending portion 12c of the transparent conductive film 12D was constituted only by the projecting portion 12d projecting from the one side edge portion 12b of the main body portion 12a. At this time, the length in the projecting direction (the direction orthogonal to the X direction in Fig. 2) of the projecting portion 12d was set to 2.1 mm and the width of the projecting portion 12d was set to 9.8 mm. In addition, the width of the facing portion 12e was set to 2.1 mm and the length of the facing portion 12e in the extending direction was set to 9.8 mm.

In addition, the transparent conductive film 12D was formed so as to have not only the main body portion 12a and the extending portion 12c but also the first current extracting portion 12f and the connecting portion 12g connecting the first current extracting portion 12f and the main body portion 12a. The transparent conductive film 12E was formed so as to have the second current extracting portion 12h. At this time, the width of the connecting portion 12g was set to 1.3 mm and the length thereof was set to 59 mm. In addition, when the resistance value of the connecting portion 12g was measured by the four probe method, it was 100 Ω.

Next, a precursor of the connection terminal 16 constituted by the conductive material connecting portion 16A and the conductive material non-connecting portion 16B was formed on the extending portion 12c of the transparent conductive films 12A to 12C. Specifically, the precursor of the connection terminal 16 was formed such that a precursor of the conductive material connecting portion 16A was provided on the facing portion 12e and a precursor of the conductive material non-connecting portion 16B was provided on the projecting portion 12d. At this time, the precursor of the conductive material non-connecting portion 16B was formed so as to be narrower than the width of the conductive material connecting portion 16A. The precursor of the connection terminal 16 was formed by applying the silver paste ("GL-6000X16" manufactured by FUKUDA METAL FOIL & POWDER Co., LTD.) by screen printing and drying it.

Furthermore, a precursor of the current collecting wiring 17 was formed on the connecting portion 12g of the transparent conductive film 12D. The precursor of the current collecting wiring 17 was formed by applying the silver paste by screen printing and drying it.

In addition, precursors of the external connection terminals 18a and 18b for extracting the current to the outside were formed on the first current extracting portion 12f and the second current extracting portion 12h of the transparent conductive film 12A, respectively. The precursors of the external connection terminals were formed by applying the silver paste by screen printing and drying it.

Furthermore, a precursor of the oxide semiconductor layer 13 was formed on the main body portion 12a of each of the transparent conductive films 12A to 12D. The precursor of the oxide semiconductor layer 13 was formed by applying the paste for porous oxide semiconductor layer formation containing titania ("PST-21NR" manufactured by JGC C & C) three times by screen printing and drying it, and then by further applying the paste for porous oxide semiconductor layer formation containing titania ("PST-400C" manufactured by JGC C & C) by screen printing and then drying it.

Moreover, a precursor of the insulating material 33 was formed so as to enter into the first groove 90A and to cover the edge portion of the main body portion 12a forming the first groove 90A. The insulating material 33 was formed by applying a paste containing a glass frit by screen printing and drying it. At this time, the width of the edge portion of the transparent conductive film covered with the insulating material 33 was 0.2 mm from the groove 90.

In addition, in order to fix the back sheet 80, in the same manner as the insulating material 33, a precursor of the annular coupling portion 14 composed of a glass frit was formed so as to surround the insulating material 33 and to pass through the transparent conductive film 12D, the transparent conductive film 12E, and the transparent conductive film 12F. In addition, at this time, the precursor of the coupling portion 14 was formed such that the precursor of the current collecting wiring 17 was disposed on the inner side thereof. In addition, the coupling portion 14 was formed such that the first current extracting portion and the second current extracting portion were disposed on the outer side thereof. The coupling portion 14 was formed by applying a paste containing a glass frit by screen printing and drying it.

Next, the precursor of the connection terminal 16, the precursor of the current collecting wiring 17, the precursors of the external connection terminals 18a and 18b, the precursor of the insulating material 33, the precursor of the coupling portion 14, the precursor of the insulating material 33, and the precursor of the oxide semiconductor layer 13 were fired at 500°C for 15 minutes to form the connection terminal 16, the current collecting wiring 17, the external connection terminals 18a and 18b, the coupling portion 14, the insulating material 33, and the oxide semiconductor layer 13. At this time, the width of the conductive material connecting portion of the connection terminal 16 was 1.0 mm and the width of the conductive material non-connecting portion thereof was 0.3 mm. In addition, the length along the extending direction of the conductive material connecting portion was 7.0 mm and the length along the extending direction of the conductive material non-connecting portion was 7.0 mm. In addition, the dimensions of the current collecting wiring 17, the external connection terminals 18a and 18b, the coupling portion 14, and the oxide semiconductor layer 13 were as follows, respectively.

Current collecting wiring 17: 4 $\mu$m in thickness, 200 $\mu$m in width, 79 mm in length along the X direction in Fig. 2, and 21 mm in length along the direction orthogonal to the X direction in Fig. 2,

External connection terminals 18a and 18b: 20 $\mu$m in thickness, 2 $\mu$m in width, and 7 mm in length,

Coupling portion 14: 50 $\mu$m, 3 mm in width, and Oxide semiconductor layer 13: 13 $\mu$m in thickness, 17 mm in length in the X direction in Fig. 2, and 42.1 mm in length in the direction orthogonal to the X direction in Fig. 2

Next, the working electrode was immersed for a whole day and night in a dye solution containing 0.2 mM of a photosensitizing dye consisting of N719 and using a mixed solvent prepared by mixing acetonitrile and tert-butanol at a volume ratio of 1 : 1 as the solvent, and then taken out therefrom and dried, and thus the photosensitizing dye was supported on the oxide semiconductor layer.

Next, the electrolyte composed of 2 M of hexylmethylimidazolium iodide, 0.3 M of n-methylbenzimidazole, 0.1 M of guanidinium thiocyanate in a solvent composed of 3-methoxypropionitrile was coated on the oxide semiconductor layer and dried, and the electrolyte was disposed.

Next, the first integrated sealing portion forming body for forming the first sealing portion was prepared. The first integrated sealing portion forming body was obtained by preparing one sheet of resin film for sealing formed by a maleic anhydride modified polyethylene (trade name: Bynel, manufactured by Du Pont) and having a size of 8.0 cm $\times$ 4.6 cm $\times$ 50 $\mu$m, and forming four quadrangular-shaped openings in the resin film for sealing. At this time, the first integrated sealing portion forming body was fabricated such that each opening had a size of 1.7 cm $\times$ 4.4 cm $\times$ 50 $\mu$m, the width of the annular portion was 2 mm, and the width of the partitioning portion partitioning the inner side opening of the annular portion was 2.6 mm.

Thereafter, the first integrated sealing portion forming body was superimposed on the insulating material 33 on the working electrode and then the first integrated sealing portion forming body was adhered to the insulating material 33 on the working electrode by heating to melt.

Next, four sheets of the counter electrodes were prepared. Two counter electrodes of the four sheets of the counter electrodes were prepared by forming the catalyst layer which had a thickness of 5 nm and was composed of platinum on the titanium foil of 4.6 cm $\times$ 1.9 cm $\times$ 40 $\mu$m by the sputtering method. The remaining two counter electrodes of the four sheets of the counter electrodes were prepared by forming the catalyst layer which had a thickness of 5 nm and was composed of platinum on the titanium foil of 4.6 cm $\times$ 2.0 cm $\times$ 40 $\mu$m by the sputtering method. In addition, another first integrated sealing portion forming body was prepared and this first integrated sealing portion forming body was adhered to the surface facing the working electrode of the counter electrode in the same manner as above.

Thereafter, the first integrated sealing portion forming body adhered to the working electrode was allowed to face the first integrated sealing portion forming body adhered to the counter electrode, and thus the first integrated sealing portion forming bodies were superimposed on each other. The first integrated sealing portion forming bodies were then melted by heating while a pressure was applied to the first integrated sealing portion forming bodies in this state. The first sealing portion was formed between the working electrode and the counter electrode in this manner. At this time, the width P of the adhesive portion of the partitioning portion of the first integrated sealing portion with the surface on the transparent conductive substrate side of the counter electrode, the width Q of the adhesive portion of the annular portion of the first integrated sealing portion with the surface on the transparent conductive substrate side of the counter electrode, the width R of the partitioning portion of the first integrated sealing portion, the width T of the annular portion and the distance H2 between the transparent conductive substrate 15 and the surface 20b of the counter electrode 20 thereof were as follows, respectively.

P = 1.0 mm
Q = 2.0 mm
R = 2.6 mm
T = 2.2 mm
H2 = 0.08 mm

Next, a second integrated sealing portion was prepared. The second integrated sealing portion was obtained by preparing one sheet of a resin film for sealing formed by maleic anhydride-modified polyethylene (trade name: Bynel, manufactured by DuPont) and having a size of 8.0 cm $\times$ 4.6 cm $\times$ 50 $\mu$m, and forming four rectangular-shaped openings in the resin film for sealing. At this time, the second integrated sealing portion was prepared such that each opening would have a size of 1.7 cm $\times$ 4.4 cm $\times$ 50 $\mu$m, the width of the annular portion would be 2 mm, the width of the partitioning portion that partitioned the inner opening of the annular portion would be 2.6 mm, and the width of the protruding portion provided continuously to the inner opening side of the annular portion and the partitioning portion would be 0.3 mm. The second integrated sealing portion was stuck to the counter electrode such that the second integrated sealing portion sandwiched the edge of the counter electrode together with the first integrated sealing portion. At this time, the second integrated sealing portion was stuck to the counter electrode and the first integrated sealing portion by heating a heating jig formed by a frame-shaped brass member and having the same shape as that of the second integrated sealing portion, pressing the heating jig against the second integrated sealing portion and then heating and melting the first integrated sealing portion and the second integrated sealing portion.

Next, the drying material sheet was stuck to the metal substrate of each counter electrode by the adhesive material formed by a double-sided tape. The dimension of the drying material sheet was 1 mm thick × 3 cm long × 1 cm wide, and Zeosheet (trade name, manufactured by Shinagawa Chemicals Co., Ltd.) was used as the drying material sheet. At this time, the drying material was disposed to be separated from the second integrated sealing portion.

Next, as illustrated in Fig. 2, the bypass diodes 70A to 70C were respectively fixed to the three partitioning portions of the second integrated sealing portion by applying the low-temperature curing type silver paste (Dotite D500 manufactured by FUJIKURAKASEI CO., LTD.) so as to continue from the terminals at both ends of the bypass diode to the metal substrate 21 of the counter electrode 20. In addition, the bypass diode 70D was fixed on the annular portion of the second integrated sealing portion of the DSC 50D among the four DSCs 50A to 50D by applying the above low-temperature curing type silver paste so as to continue from one terminal of the terminals at both ends of the diode to the counter electrode. In this manner, the conductive material 60Q was formed so as to link the two adjacent bypass diodes with respect to the four bypass diodes 70A to 70D. At this time, the conductive material 60Q was formed by curing the above low-temperature curing type silver paste at 30°C for 12 hours. RB751V-40 manufactured by ROHM was used as the bypass diode.

In addition, the conductive material 60P was formed by applying the low-temperature curing type silver paste (Dotite D-500 manufactured by FUJIKURAKASEI CO., LTD.) so as to connect each of the conductive materials 60Q between the bypass diodes and the conductive material connecting portion on the three transparent conductive films 12A to 12C, respectively and curing it. Moreover, for the bypass diode 70A, the conductive material 60P was formed by applying the above low-temperature curing type silver paste so as to be connected with the conductive material connecting portion on the transparent conductive film 12E and curing it. At this time, the conductive material 60P was formed by curing the above low-temperature curing type silver paste at 30°C for 12 hours.

Next, butyl rubber ("AICA Melt" manufactured by Aica Kogyo Co., Ltd.) was applied onto the connecting portion 14 with a dispenser while being heated at 200°C to form a precursor of the adhesive part. Meanwhile, a laminate, which is obtained by laminating a polybutylene terephthalate (PBT) resin film (50 $\mu$m in thickness), aluminum foil (25 $\mu$m in thickness), and a film (50 $\mu$m in thickness) formed by Bynel (trade name, manufactured by Du Pont) in this order, was prepared. Then, the peripheral edge of this laminate was superimposed on the precursor of the adhesive part 91, and a pressure was applied thereto for 10 seconds. In this manner, the peripheral edge 80a of the back sheet 80 was adhered to the connecting portion 14 with the adhesive part 91 having a thickness of 0.2 mm interposed therebetween. That is, the back sheet 80 configured by an adhesive part 80B and a laminate 80A was fixed to the connecting portion 14. At this time, the first space was formed between the back sheet and an outer region of the counter electrode with respect to the interface between the drying material and the counter electrode such that the first space was in contact with the outer region and the drying material. Further, the first space and the second space were communicated with each other by forming the second space between the sealing portion and the back sheet 80, and making the back sheet 80 and DSC 50 be not in contact with each other. In the above manner, the DSC module was obtained. In this DSC module, the distance (first distance) H1 between the transparent conductive substrate 15 and the interface between the adhesive part 91 and the back sheet 80 was 0.25 mm. Further, in the obtained DSC module, the connection terminal 16 and the current collecting wiring 17 were provided at the outer side of the sealing portion 30A and the inner side of the outer peripheral surface of the adhesive part 91.

(Example 2)

A DSC module was prepared in the same manner as in Example 1, except that a second integrated sealing portion was prepared such that the width of the protruding portion provided continuously to the inner opening side of the annular portion and the partitioning portion would be 0 mm.

(Example 3)

A DSC module was prepared in the same manner as in Example 1, except that a double-sided tape was stuck onto the drying material sheet before the peripheral edge of the back sheet 80 was adhered to the connecting portion 14, the peripheral edge of the back sheet 80 was adhered to the connecting portion 14 with the adhesive part 91 interposed therebetween, and then the back sheet 80 was pressed toward the counter electrode side to connect the drying material sheet and the back sheet by the double-sided tape.

(Example 4)

A DSC module was prepared in the same manner as in Example 1, except that the drying material sheet was not stuck to the counter electrode before the peripheral edge of the back sheet 80 was adhered to the connecting portion 14 with the adhesive part 91 interposed therebetween.

(Example 5)

A DSC module was prepared in the same manner as in Example 1, except that, instead of pasting the drying material sheet to the counter electrode before the peripheral edge of the back sheet 80 was adhered to the connecting portion 14 with the adhesive part 91 interposed therebetween, an adhesive material formed by an acrylic resin and having a thickness of 50 $\mu$m was adhered to the counter electrode, the peripheral edge of the back sheet 80 was adhered to the connecting portion 14 with the adhesive part 91 interposed therebetween, and then the back sheet 80 was pressed toward the counter electrode side to connect the counter electrode and the back sheet by the adhesive material.

(Example 6)

A DSC module was prepared in the same manner as in Example 1, except that the second space was not formed between the back sheet and the sealing portion by making the connecting portion 14 and the adhesive part 80B be in close contact with the sealing portion.

(Example 7)

A DSC module was prepared in the same manner as in Example 1, except that the first space and the second space were not communicated with each other by providing the back sheet to be in contact with the second integrated sealing portion.

(Example 8)

A DSC module was prepared in the same manner as in Example 1, except that a sheet-shaped drying material was further pasted onto the second integrated sealing portion to be provided across the counter electrodes of the two adjacent DSCs.
Incidentally, the dimension of the sheet-shaped drying material was 1 mm thick $\times$ 3 cm long $\times$ 1 cm wide, and Zeosheet (trade name, manufactured by Shinagawa Chemicals Co., Ltd.) was used as the sheet-shaped drying material.

(Example 9)

A DSC module was prepared in the same manner as in Example 1, except that a precursor of the second porous inorganic portion 34B was formed at the same time as the precursor of the oxide semiconductor layer 13 was formed by applying the same material as that of the paste for forming a porous oxide semiconductor layer to a part of the edge of the main body portion 12a on the transparent conductive substrate 15 by screen printing, and then the second porous inorganic portion 34B was formed by calcining the precursor of the second porous inorganic portion 34B at the same time as the precursor of the oxide semiconductor layer 13 or the like was calcined at 500°C for 15 minutes.

(Comparative Example 1)

A DSC module was prepared in the same manner as in Example 1, except that a current collector to have a width of 200 $\mu$m extending from the end to the end of the sealing portion in the direction perpendicular to the arrangement direction X and connected to the connection terminal 16 or the current collecting wiring 17 at the outer side of the sealing portion was formed between the first sealing portion and the inorganic insulating material of each DSC 50. One current collecting wiring was provided to each of DSCs 50.

(Comparative Example 2)

A DSC module was prepared in the same manner as in Comparative Example 1, except that the width of the sealing portion including the current collecting wiring was set to two times and the area of the oxide semiconductor layer as the power generation layer was reduced by the increase in the width of the sealing portion.

(Property Evaluation)

(Durability and Initial Photoelectric Conversion Efficiency)

As for each of the DSC modules obtained in Examples 1 to 9 and Comparative Examples 1 and 2, initial photoelectric conversion efficiency immediately after preparation was measured at an illuminance of 200 lux. Further, as for each of the DSC modules, the time until the photoelectric conversion efficiency obtained when the DSC module was left under the environmental of a high temperature of 85°C was decreased to 10% with respect to the initial photoelectric conversion efficiency was measured. Specifically, photoelectric conversion efficiency was measured by taking the module out per 250 hours. The results are presented in Table 1. In Table 1, the initial photoelectric conversion efficiency indicates the initial photoelectric conversion efficiency of each of Examples 1 to 9 and Comparative Examples 1 and 2 when the initial photoelectric conversion efficiency of Comparative Example 1 is assumed to be 100.

[Table 1]

| | Durability | Initial photoelectric conversion efficiency (%) |
| --- | --- | --- |
| | Time (h) | |
| Example 1 | 2500 | 98 |
| Example 2 | 2500 | 100 |
| Example 3 | 2500 | 101 |
| Example 4 | 2250 | 99 |
| Example 5 | 2250 | 98 |
| Example 6 | 2500 | 101 |
| Example 7 | 2500 | 100 |
| Example 8 | 2500 | 97 |
| Example 9 | 2500 | 101 |
| Comparative Example 1 | 1250 | 100 |
| Comparative Example 2 | 2000 | 84 |

(Durability and Short Circuit Occurrence)

Further, as for each of the DSC modules obtained in Examples 2 to 5, the photoelectric conversion efficiency ($\eta_0$) was measured. Subsequently, as for each of the DSC modules obtained in Examples 2 to 5, the photoelectric conversion efficiency ($\eta$) was also measured after a heat cycle test was performed according to JIS C 8938. Then, the retention rate of the photoelectric conversion efficiency (photoelectric conversion retention rate) was calculated on the basis of the following expression.

$$\text{Retention rate (\%) of photoelectric conversion}$$

$$\text{efficiency} = \eta/\eta_0 \times 100$$

The results are presented in Table 1. Further, after the heat cycle test, as for each of the DSC modules obtained in Examples 2 to 5, presence or absence of short circuit occurrence was examined by applying a tester to the back sheet and the counter electrode to measure a resistance value therebetween. Here, a case where the resistance value was less than 1 MΩ was determined as the presence of short circuit, and a case where the resistance value was 1 MΩ or more was determined as the absence of short circuit. The results are presented in Table 2.

[Table 2]

| | Durability | Presence or absence of short circuit |
|---|---|---|
| | Retention rate of photoelectric conversion efficiency (%) | |
| Example 2 | 87 | Absence |
| Example 3 | 87 | Absence |
| Example 4 | 85 | Absence |
| Example 5 | 86 | Absence |

From the results presented in Table 1, it was found that the DSC modules of Examples 1 to 9 exhibited high durability and initial photoelectric conversion efficiency. On the other hand, it was found that the DSC module of Comparative Example 1 exhibited high initial photoelectric conversion efficiency but durability thereof was not sufficient, and the DSC module of Comparative Example 2 exhibited sufficient durability but initial photoelectric conversion efficiency thereof was low.

From the above description, it was confirmed that the DSC module of the invention had excellent durability and conversion efficiency.

Incidentally, from the results presented in Table 2, it was found that the DSC modules of Examples 2 to 5 exhibited high photoelectric conversion retention rate. Further, from the results presented in Table 2, it was found that the short circuit did not occur in the DSC modules of Examples 2 to 5.

EXPLANATIONS OF LETTERS OR NUMERALS

11: Transparent substrate (insulating substrate)
12: Transparent conductive film (conductive film)
13: Oxide semiconductor layer (power generation layer)
14: Connecting portion
14a: Annular region
15: Transparent conductive substrate (conductive substrate, first electrode)
16: Connection terminal
17: Current collecting wiring
18: External connecting portion
19: Current collector
20: Counter electrode (counter substrate, second electrode)
20b: Interface between counter electrode and drying material
20c: Outer region of interface
30A: Sealing portion
31: First integrated sealing portion (first sealing portion)
31A: First sealing portion
31a, 32a: Annular portion
31b, 32b: Partitioning portion
32: Second integrated sealing portion (second sealing portion)
32A, 32B: Second sealing portion
32d: Protruding portion
33: Inorganic insulating material
40: Electrolyte
50, 50A to 50D: Dye-sensitized solar cell
80: Back sheet
91: Adhesive part
91a: Outer peripheral surface
95, 701: Drying material
96: First space
97: Second space
98, 398, 399: Adhesive material

100 to 1000: Dye-sensitized solar cell module (dye-sensitized solar cell element)
1100: Dye-sensitized solar cell element
H1: Distance between transparent conductive substrate and interface between adhesive part and back sheet
H2: Distance between transparent conductive substrate and surface of counter electrode at the back sheet side

**Claims**

1. A dye-sensitized solar cell element comprising:

    at least one dye-sensitized solar cell; and
    a back sheet facing the at least one dye-sensitized solar cell,
    the at least one dye-sensitized solar cell including a conductive substrate,
    a current collector disposed on the conductive substrate,
    a counter substrate facing the conductive substrate,
    a power generation layer disposed on the conductive substrate or the counter substrate,
    an electrolyte disposed between the conductive substrate and the counter substrate, and
    an annular sealing portion enclosing the power generation layer and the electrolyte together with the conductive substrate and the counter substrate and joining the conductive substrate and the counter substrate, and
    the dye-sensitized solar cell element further comprising:

       an adhesive part adhering the back sheet and the conductive substrate in an annular region surrounding the at least one dye-sensitized solar cell,
       wherein the current collector is provided only at an outer side of the sealing portion and only at an inner side of an outer peripheral surface of the adhesive part.

2. The dye-sensitized solar cell element according to claim 1, wherein the adhesive part is separated from the sealing portion.

3. The dye-sensitized solar cell element according to claim 2, further comprising an external connecting portion for extracting current to the outside on the conductive substrate and only at an outer side of the adhesive part.

4. The dye-sensitized solar cell element according to claim 2 or 3, wherein
    the conductive substrate is configured by a first electrode having an insulating substrate,
    the counter substrate is configured by a second electrode,
    the back sheet has a metal layer,
    the annular region is positioned on the insulating substrate at the back sheet side,
    the adhesive part adheres the back sheet and the annular region,
    the second electrode is disposed between the first electrode and the back sheet, and
    a distance between the first electrode and an interface between the back sheet and the adhesive part is larger than a distance between the first electrode and a surface of the second electrode at the back sheet side.

5. The dye-sensitized solar cell element according to claim 4, wherein the second electrode and the back sheet in the at least one dye-sensitized solar cell are connected to each other by an adhesive material.

6. The dye-sensitized solar cell element according to claim 4 or 5, wherein the at least one dye-sensitized solar cell further includes a drying material provided between the second electrode and the back sheet.

7. The dye-sensitized solar cell element according to claim 6, wherein
    the drying material and the second electrode are connected to each other by an adhesive material, and
    the drying material and the back sheet are connected to each other by an adhesive material.

8. The dye-sensitized solar cell element according to claim 6 or 7, wherein
    the second electrode is provided between the first electrode and the back sheet,
    the drying material is disposed between the second electrode and the back sheet to be in contact with the second electrode, and
    a first space is formed between the back sheet and an outer region of the second electrode at the interface between the drying material and the second electrode such that the first space is in contact with the outer region and the drying material.

9. The dye-sensitized solar cell element according to any one of claims 1 to 8, wherein
the at least one dye-sensitized solar cell is configured by a plurality of dye-sensitized solar cells,
the conductive substrate has a conductive film provided on the insulating substrate,
the insulating substrate of the plurality of dye-sensitized solar cells is used as an insulating substrate that is common to the plurality of dye-sensitized solar cells, and
each of the conductive film of the plurality of dye-sensitized solar cells is provided on the common transparent substrate.

10. The dye-sensitized solar cell element according to claim 9, wherein the current collector is provided at the outer side of the sealing portion and only at a portion other than the portion between the two adjacent dye-sensitized solar cells.

# Fig.1

# Fig.2

# Fig.3

# Fig.4

# Fig.5

# Fig.6

# Fig.7

# Fig.8

131

131a — 20 — 131A

131a — 20 — 131A

131a — 20 — 131A

131a — 20 — 131A

# Fig.9

# Fig.10

# Fig.11

Fig.12

# Fig.13

EP 2 955 781 A1

EP 2 955 781 A1

# Fig.14

400

80a 30A 31A 32A 20a 20b 95 398 20 22 21 50(50D) 20a 32 20 22 21 20b 95 398 50(50C) 20a 20b 95 398 20 22 21 50(50B) 20a 95 398 20b 20 22 21 50(50A) 20a 80a

80
91a
91
14a
14
H1
H2
40 40 40 40
91b
18a
14

12(12F)
33
90A(90)
11 12(12D)
15 13
10
90A(90)
32A
31A
33
30A
11 12(12C)
15 13
10
90A(90)
32A
31A
33
30A
11 12(12B)
15 13
10
90A(90)
32A
31A
33
30A
11 12(12A)
15 13
10
90A(90)
17
12f(12D)

# Fig.15

EP 2 955 781 A1

# Fig.16

EP 2 955 781 A1

# Fig.17

Fig.18

# Fig.19

# Fig.20

# Fig.21

# Fig.22

# Fig.23

<div align="center">**INTERNATIONAL SEARCH REPORT**</div>

| International application No. |
| --- |
| PCT/JP2013/083823 |

**A. CLASSIFICATION OF SUBJECT MATTER**
*H01M14/00*(2006.01)i, *H01L31/04*(2014.01)i

According to International Patent Classification (IPC) or to both national classification and IPC

**B. FIELDS SEARCHED**

Minimum documentation searched (classification system followed by classification symbols)
H01M14/00, H01L31/04

Documentation searched other than minimum documentation to the extent that such documents are included in the fields searched
Jitsuyo Shinan Koho          1922–1996   Jitsuyo Shinan Toroku Koho   1996–2014
Kokai Jitsuyo Shinan Koho    1971–2014   Toroku Jitsuyo Shinan Koho   1994–2014

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| A | JP 2010-113905 A  (Sony Corp.), 20 May 2010 (20.05.2010), claims & US 2010/0269892 A1     & EP 2219262 A1 & WO 2010/053105 A1 | 1-10 |
| A | WO 2011/155441 A1  (Sharp Corp.), 15 December 2011 (15.12.2011), claims & EP 2581981 A1 | 1-10 |
| A | WO 2009/144898 A1  (Fujikura Ltd.), 03 December 2009 (03.12.2009), claims & JP 5255632 B          & US 2011/0120520 A1 & EP 2287959 A1 | 1-10 |

☐ Further documents are listed in the continuation of Box C.     ☐ See patent family annex.

\* Special categories of cited documents:
"A" document defining the general state of the art which is not considered   to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
| --- | --- |
| 10 January, 2014 (10.01.14) | 21 January, 2014 (21.01.14) |

| Name and mailing address of the ISA/ Japanese Patent Office | Authorized officer |
| --- | --- |
| Facsimile No. | Telephone No. |

Form PCT/ISA/210 (second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2006244954 A

- JP 2006100069 A